# EUROPEAN PATENT APPLICATION

(11) **EP 4 788 069 A1**
(43) Date of publication of application: **05.08.2026**
(21) Application number: 24938661.6
(22) Date of filing: 17.12.2024
(51) Int. Cl.: H05K 5/02, G06F 1/16, F16C 11/04

(54) **ACCESSORY APPARATUS AND ELECTRONIC DEVICE**

(30) Priority: 14.05.2024 CN 202410598666
(71) Applicant: Huawei Technologies Co., Ltd., Shenzhen, Guangdong 518129 (CN)
(72) Inventor: WEI, Qinan, Shenzhen, Guangdong 518129 (CN); RAO, Yingchun, Shenzhen, Guangdong 518129 (CN); PENG, Lexiong, Shenzhen, Guangdong 518129 (CN); CHEN, Suo, Shenzhen, Guangdong 518129 (CN); TU, Yiming, Shenzhen, Guangdong 518129 (CN); ZHAO, Jie, Shenzhen, Guangdong 518129 (CN)
(74) Representative: Maiwald GmbH
(86) International application number: PCT/CN2024/139938
(87) International publication number: WO 2025/236657

(57) **Abstract**

This application provides an accessory apparatus and an electronic device. The accessory apparatus includes a body, a first support plate, a second support plate, and a third support plate. The first support plate includes a first plate edge and a second plate edge that are disposed opposite to each other, the second support plate includes a third plate edge and a fourth plate edge that are disposed opposite to each other, the first plate edge is rotatably connected to the third plate edge, the second plate edge is rotatably connected to an end portion of the body, the fourth plate edge is rotatably connected to the third support plate, and the third support plate may be configured to be detachably connected to a host of the electronic device. In the accessory apparatus provided in this application, a multi-link transmission principle is used, to form reliable support for the host of the electronic device while meeting a requirement for smoothly opening the electronic device. A structure of the accessory apparatus is simple. This helps implement a miniaturization design of the accessory apparatus, and further meets a design requirement for light weight, thinness, and miniaturization of the electronic device, to meet a portability requirement of a user and improve user experience.

## Description

### CROSS-REFERENCE TO RELATED APPLICATIONS

This application claims priority to Chinese Patent Application No. 202410598666.5, filed with the China National Intellectual Property Administration on May 14, 2024 and entitled "ACCESSORY APPARATUS AND ELECTRONIC DEVICE", which is incorporated herein by reference in its entirety.

### TECHNICAL FIELD

This application relates to the field of electronic device technologies, and in particular, to an accessory apparatus and an electronic device.

### BACKGROUND

With rich daily life and increasing economic and commercial activities of people, an electronic device like a table computer becomes one of indispensable terminal products. To improve use convenience of the electronic device like the table computer, a supporting accessory apparatus is usually disposed for the electronic device like the table computer, to protect the electronic device like the table computer and support the electronic device like the table computer in a use state.

Usually, to improve a use feel and support stability, a damping structure is usually disposed in the accessory apparatus for implementing the foregoing functions, to generate, in a process of opening the accessory apparatus, torque that hinders movement of the accessory apparatus. However, in a current design, the damping structure in the accessory apparatus generates constant torque in the process of opening the accessory apparatus. If the torque is large, the accessory apparatus can be opened only by using a large opening force. This affects user experience.

### SUMMARY

This application provides an accessory apparatus and an electronic device, to achieve variable torque in a process of opening the accessory apparatus, thereby improving convenience of opening the accessory apparatus and improving user experience.

According to a first aspect, this application provides an accessory apparatus. The accessory apparatus includes a body, a first support plate, a second support plate, a third support plate, and a rotating shaft assembly, the first support plate, the second support plate, and the third support plate are rotatably connected in sequence, and the first support plate is rotatably connected to an end portion of the body by using the rotating shaft assembly. In this application, the rotating shaft assembly includes a first shaft, a second shaft, a conjoined cam, a first cam member, and a second cam member, an axis of the first shaft and an axis of the second shaft are parallel and do not overlap, the first shaft is fastened to the first support plate, and the second shaft is fastened to an end portion of the body. The conjoined cam is sleeved on the first shaft and the second shaft, the first cam member is sleeved on the first shaft, and the second cam member is sleeved on the second shaft. The first shaft includes a first limiting structure, and when the accessory apparatus is in a closed state, the first cam member abuts against an end face of the first limiting structure along an axial direction of the first shaft, and there is a clearance fit between the first cam member and the conjoined cam. In addition, when the first shaft rotates to a specified angle, the first cam member abuts against the conjoined cam. In the accessory apparatus provided in this application, the first limiting structure is disposed on the first shaft, so that torque of the rotating shaft assembly in an early stage of an opening process is small, thereby facilitating opening of the entire electronic device in which the accessory apparatus is used. In addition, the torque of the rotating shaft assembly increases when the electronic device is opened to a specified angle, so that the accessory apparatus can reliably support the host of the electronic device when the electronic device is opened to be in a use state.

In a possible implementation of this application, the first shaft includes a first rotating wheel, the first rotating wheel and the first shaft are coaxially disposed, and a peripheral side surface of the first rotating wheel includes a first groove. The second shaft includes a second rotating wheel, the second rotating wheel and the second shaft are coaxially disposed, and a peripheral side surface of the second rotating wheel includes a second groove. The first groove and the second groove are staggered. In addition, the rotating shaft assembly further includes a transfer wheel, and the transfer wheel is located between the first rotating wheel and the second rotating wheel. When the accessory apparatus is in the closed state, a part of the transfer wheel is accommodated in the second groove. When the first shaft stops rotating around the axis and the second shaft rotates around the axis, a part of the transfer wheel is accommodated in the first groove. Based on the foregoing design, the transfer wheel moves between the second groove and the first groove, so that the first shaft rotates to the specified angle and then the second shaft rotates, thereby implementing sequential movement of the two shafts of the rotating shaft assembly. This helps improve motion stability of the rotating shaft assembly and uniqueness of a motion trajectory, thereby making it possible that the accessory apparatus is opened in one step.

In a possible implementation of this application, the first rotating wheel includes a first stop portion, and the conjoined cam includes a second stop portion. When the first stop portion abuts against the second stop portion, the first shaft stops rotating around the axis. In this way, a rotation location of the first shaft can be stopped. This helps improve motion stability of the rotating shaft assembly.

In addition, the rotating shaft assembly further includes a snap-fit, the snap-fit is snap-fitted to the first shaft, and the snap-fit is snap-fitted to the second shaft. The conjoined cam includes a first elongated hole, the snap-fit includes a second elongated hole, and the first elongated hole is disposed opposite to the second elongated hole. The transfer wheel is located between the snap-fit and the conjoined cam, the transfer wheel includes a first guiding portion and a second guiding portion that are disposed back to back, the first guiding portion is inserted into the first elongated hole, and the second guiding portion is inserted into the second elongated hole. In this way, movement of the transfer wheel can be guided through the first elongated hole and the second elongated hole, thereby ensuring rotation stability of the rotating shaft assembly.

In a possible implementation of this application, the first rotating wheel and the first shaft are of an integral structure. In addition, the second rotating wheel and the second shaft may also be of an integral structure. This helps simplify a structure of the rotating shaft assembly, and reduce a volume of the rotating shaft assembly, thereby helping implement a lightweight and thin design of the accessory apparatus.

In this application, in addition to the foregoing disposition manner, the rotating shaft assembly may be disposed in another possible disposition manner. For example, in a possible implementation, the first shaft includes a first helical surface, the second shaft includes a second helical surface, and the first helical surface and the second helical surface have a same rotation direction. In addition, the rotating shaft assembly further includes an idler gear, the idler gear is located between the first helical surface and the second helical surface, the first helical surface is engaged with a tooth flank of the idler gear, and the second helical surface is engaged with a tooth flank of the idler gear. According to the foregoing design, the first shaft and the second shaft can rotate synchronously and reversely. This helps improve rotation stability of the first shaft and the second shaft, thereby improving stability of relative rotation between the first support plate and the body.

Based on the foregoing descriptions of a principle of achieving variable torque of the first shaft in a rotation process by disposing the first limiting structure on the first shaft, in a possible implementation of this application, the second shaft may include a second limiting structure. In this way, when the accessory apparatus is in the closed state, the second cam member abuts against an end face of the second limiting structure along an axial direction of the second shaft, and there is a clearance fit between the second cam member and the conjoined cam. In addition, when the second shaft rotates to a specified angle, the second cam member abuts against the conjoined cam. In this way, variable torque of the two shafts can be achieved in a process in which the first shaft and the second shaft rotate synchronously, so that the torque of the rotating shaft assembly in the early stage of the opening process of the electronic device is small, thereby facilitating opening of the entire electronic device. In addition, the torque of the rotating shaft assembly increases when the electronic device is opened to the specified angle, so that the accessory apparatus can reliably support the host of the electronic device when the electronic device is opened to be in a use state.

In addition, the rotating shaft assembly further includes a connecting member, a first stop member, and a second stop member. The connecting member is sleeved on the first shaft and the second shaft, the first stop member is sleeved on the first shaft, and the second stop member is sleeved on the second shaft. In a rotation direction of the first shaft, a relative location between the first stop member and the first shaft is fixed. In other words, the first stop member may rotate synchronously with the first shaft. In addition, in a rotation direction of the second shaft, a relative location between the second stop member and the second shaft is fixed. In other words, the second stop member may rotate synchronously with the second shaft. In this way, when the first stop member abuts against the connecting member and the second stop member abuts against the connecting member, the first support plate stops rotating toward a side away from the body. This can help improve stability of supporting the host of the electronic device by the accessory apparatus in the open state.

In this application, the first stop member may be located between the connecting member and the conjoined cam, and the second stop member may be located between the connecting member and the conjoined cam. This helps improve structural compactness of the rotating shaft assembly, thereby helping reduce a size of the rotating shaft assembly, so that the rotating shaft assembly can meet a requirement for a lightweight and thin design of the accessory apparatus.

In a possible implementation of this application, the rotating shaft assembly may further include a first elastic component and a second elastic component, the first elastic component is sleeved on the first shaft, the first cam member is located between the conjoined cam and the first elastic component, and the first elastic component abuts against an end face that is of the first cam member and that is away from the conjoined cam. In this way, the first elastic component can press the first cam member toward the conjoined cam. The second elastic component is sleeved on the second shaft, the second cam member is located between the conjoined cam and the second elastic component, and the second elastic component abuts against an end face that is of the second cam member and that is away from the conjoined cam. In this way, the second elastic component can press the second cam member toward the conjoined cam. In this way, reliability when a corresponding cam member abuts against the conjoined cam can be ensured, thereby helping improve motion stability of the rotating shaft assembly.

According to a second aspect, this application further provides an accessory apparatus. The accessory apparatus includes a body, a first support plate, a second support plate, a third support plate, and a rotating shaft assembly, the first support plate, the second support plate, and the third support plate are rotatably connected in sequence, and the first support plate is rotatably connected to an end portion of the body by using the rotating shaft assembly. In this application, the rotating shaft assembly includes a third shaft, a third fastening bracket, and a fourth fastening bracket, and the third fastening bracket is configured to drive the third shaft to rotate synchronously. The fourth fastening bracket is rotatably connected to the third shaft. The third fastening bracket is fastened to the second plate edge of the first support plate, and the fourth fastening bracket is fastened to an end portion of the body. For the rotating shaft assembly of the accessory apparatus provided in this application, a single-shaft design manner is used, to form reliable support for a host of an electronic device while meeting a requirement for opening the electronic device in one step. A structure of the accessory apparatus is simple. This helps implement a miniaturization design of the accessory apparatus, and further meets a design requirement for light weight, thinness, and miniaturization of the electronic device, to meet a portability requirement of a user and improve user experience.

In a possible implementation of this application, the third shaft includes a thirteenth stop portion, and the fourth fastening bracket includes a fourteenth stop portion. When the thirteenth stop portion abuts against the fourteenth stop portion, the fourth fastening bracket stops rotating. This can help improve stability of supporting the host of the electronic device by the accessory apparatus in the open state.

In a possible implementation of this application, the rotating shaft assembly further includes a third cam member, and the third shaft includes a third limiting structure; when the accessory apparatus is in a closed state, the third cam member abuts against an end face of the third limiting structure along an axial direction of the third shaft, and there is a clearance fit between the third cam member and the fourth fastening bracket; and when the third shaft rotates to a specified angle, the third cam member abuts against the fourth fastening bracket. In this way, torque of the rotating shaft assembly in an early stage of an opening process of the electronic device is small, thereby facilitating opening of the entire electronic device. In addition, the torque of the rotating shaft assembly increases when the electronic device is opened to the specified angle, so that the accessory apparatus can reliably support the host of the electronic device when the electronic device is opened to be in a use state.

In addition, the rotating shaft assembly further includes a third elastic component, the third cam member is located between the fourth fastening bracket and the third elastic component, and the third elastic component abuts against an end face that is of the third cam member and that is away from the fourth fastening bracket. In this way, reliability when the third cam member abuts against the third limiting structure or the fourth fastening bracket can be ensured, thereby ensuring motion stability of the rotating shaft assembly.

According to a third aspect, this application further provides an electronic device. The electronic device includes a host and the accessory apparatus according to the first aspect or the second aspect, and a third support plate of the accessory apparatus is detachably connected to the host. In the electronic device provided in this application, because torque of a rotating shaft assembly of the accessory apparatus in an early stage of an opening process is small, this helps open the entire electronic device. In addition, the torque of the rotating shaft assembly increases when the electronic device is opened to a specified angle, so that the accessory apparatus can reliably support the host of the electronic device when the electronic device is opened to be in a use state. In addition, a structure of the accessory apparatus is simple. This may meet a design requirement for light weight, thinness, and miniaturization of the electronic device, to meet a portability requirement of a user and improve user experience.

### BRIEF DESCRIPTION OF DRAWINGS

FIG. 1 is a diagram of an application scenario of an accessory apparatus according to an embodiment of this application;
FIG. 2 is an exploded view of an electronic device shown in FIG. 1;
FIG. 3 is a diagram of a structure in which an electronic device is in an open state as shown in FIG. 1;
FIG. 4 is an exploded view of the electronic device shown in FIG. 3;
FIG. 5a is a simple diagram of a structure of the electronic device shown in FIG. 3;
FIG. 5b is a simple diagram of a structure of the electronic device shown in FIG. 5a from another perspective;
FIG. 6 is a diagram of a structure of a rotating module according to an embodiment of this application;
FIG. 7 is a diagram of a structure of a rotating shaft assembly according to an embodiment of this application;
FIG. 8 is an exploded view of the rotating shaft assembly shown in FIG. 7;
FIG. 9a is a side view of an electronic device shown in FIG. 1;
FIG. 9b is a side view of a rotating shaft assembly when an electronic device is in a state shown in FIG. 9a;
FIG. 9c is a sectional view along A-A of the rotating shaft assembly shown in FIG. 9b;
FIG. 9d is a sectional view along B-B of the rotating shaft assembly shown in FIG. 9b;
FIG. 10a is a side view in which an electronic device is opened to a specified angle according to an embodiment of this application;
FIG. 10b is a side view of a rotating shaft assembly when an electronic device is in a state shown in FIG. 10a;
FIG. 10c is a sectional view along C-C of the rotating shaft assembly shown in FIG. 10b;
FIG. 10d is a sectional view along D-D of the rotating shaft assembly shown in FIG. 10b;
FIG. 11a is a side view in which an electronic device is opened to another angle according to an embodiment of this application;
FIG. 11b is a side view of a rotating shaft assembly when an electronic device is in a state shown in FIG. 11a;
FIG. 11c is a sectional view along E-E of the rotating shaft assembly shown in FIG. 11b;
FIG. 11d is a sectional view along F-F of the rotating shaft assembly shown in FIG. 11b;
FIG. 12a is a side view in which an electronic device is in an open state according to an embodiment of this application;
FIG. 12b is a side view of a rotating shaft assembly when an electronic device is in a state shown in FIG. 12a;
FIG. 12c is a sectional view along G-G of the rotating shaft assembly shown in FIG. 12b;
FIG. 12d is a sectional view along H-H of the rotating shaft assembly shown in FIG. 12b;
FIG. 13 is a principle diagram of a motion mechanism of an accessory apparatus in which the rotating shaft assembly provided in the foregoing embodiments is used according to this application;
FIG. 14a is a diagram of a structure of the rotating shaft assembly shown in FIG. 9b from another perspective;
FIG. 14b is a diagram of a structure of a first cam member according to an embodiment of this application;
FIG. 14c is a sectional view along I-I of the rotating shaft assembly shown in FIG. 14a;
FIG. 14d is an enlarged view of a partial structure at a location J of a structure shown in FIG. 14c;
FIG. 14e is an X-direction view of the first cam member 318 shown in FIG. 14b;
FIG. 15a is a diagram of a structure of the rotating shaft assembly shown in FIG. 10b from another perspective;
FIG. 15b is a sectional view along K-K of the rotating shaft assembly shown in FIG. 15a;
FIG. 15c is an enlarged view of a partial structure at a location L of a structure shown in FIG. 15b;
FIG. 16 is a diagram of another structure of a rotating shaft assembly according to an embodiment of this application;
FIG. 17 is a diagram of another structure of a rotating shaft assembly according to an embodiment of this application;
FIG. 18 is an exploded view of the rotating shaft assembly shown in FIG. 17;
FIG. 19 is a sectional view along M-M of the rotating shaft assembly shown in FIG. 17;
FIG. 20a is a side view in which the rotating shaft assembly shown in FIG. 17 is opened to a specified angle;
FIG. 20b is a sectional view along N-N of the rotating shaft assembly shown in FIG. 20a;
FIG. 21a is a side view in which the rotating shaft assembly shown in FIG. 17 is opened to another angle;
FIG. 21b is a sectional view along O-O of the rotating shaft assembly shown in FIG. 21a;
FIG. 22a is a diagram of a structure of a rotating shaft assembly in an open state;
FIG. 22b is a sectional view along P-P of the rotating shaft assembly shown in FIG. 22a;
FIG. 23a is a diagram of a structure of the rotating shaft assembly shown in FIG. 17 from another perspective;
FIG. 23b is a sectional view along Q-Q of the rotating shaft assembly shown in FIG. 23a;
FIG. 23c is an enlarged view of a partial structure at a location R of a structure shown in FIG. 23b;
FIG. 24a is a diagram of a structure of the rotating shaft assembly shown in FIG. 17 from another perspective;
FIG. 24b is an enlarged view of a partial structure at a location S of the rotating shaft assembly shown in FIG. 24a;
FIG. 25a is a diagram of a structure of the rotating shaft assembly shown in FIG. 21a from another perspective;
FIG. 25b is an enlarged view of a partial structure at a location T of the rotating shaft assembly shown in FIG. 25a;
FIG. 26a is a diagram of a structure of the rotating shaft assembly shown in FIG. 21a from another perspective;
FIG. 26b is a sectional view along U-U of the rotating shaft assembly shown in FIG. 26a;
FIG. 27 is a diagram of another structure of an accessory apparatus according to an embodiment of this application;
FIG. 28 is a diagram of a structure of a rotating shaft assembly of the accessory apparatus shown in FIG. 27;
FIG. 29 is an exploded view of the rotating shaft assembly shown in FIG. 28;
FIG. 30 is a principle diagram of a motion mechanism of the accessory apparatus shown in FIG. 27;
FIG. 31 is a diagram of a structure in which an electronic device is opened to a specified angle;
FIG. 32 is a diagram of a structure in which an electronic device is in an open state;
FIG. 33 is a diagram of a structure in which an electronic device is in a closed state; and
FIG. 34 is a diagram of a structure of a rotating shaft assembly when an accessory apparatus is in the open state shown in FIG. 32.

Reference numerals:
1000: accessory apparatus; 1: body; 101: button; 102: touch panel; 103: second magnetic member;
2: support component; 201: first support plate; 2011: first plate edge; 2012: second plate edge;
202: second support plate; 2021: third plate edge; 2022: fourth plate edge; 203: third support plate; 2031: fifth plate edge;
3: rotating module; 31: rotating shaft assembly; 311: first shaft; 3111: first rotating wheel; 31111: first groove; 31112: first stop portion;
31113: first limiting structure; 31101: first helical surface; 312: second shaft; 3121: second rotating wheel; 31211: second groove;
31212: third stop portion; 3122: second helical surface; 3123: second limiting structure; 313: first fastening bracket; 314: second fastening bracket;
315: transfer wheel; 3151: first guiding portion; 3152: second guiding portion; 316: conjoined cam; 3161: second stop portion;
3162: fourth stop portion; 3163: first elongated hole; 3164: third cam surface; 3165: fourth cam surface; 3166: sixth stop portion;
317: snap-fit; 3171: second elongated hole; 318: first cam member; 3181: first cam surface; 3182: step surface; 3183: shaft hole;
319: second cam member; 3191: second cam surface; 3192: fifth stop portion; 3110: first elastic component; 3112: second elastic component;
3113: first nut; 3114: second nut; 3115: gasket; 3116: idler gear; 31161: rotating shaft; 3117: first stop member;
31171: seventh stop portion; 31172: ninth stop portion; 3118: second stop member; 31181: eighth stop portion; 31182: tenth stop portion;
3119: connecting member; 31191: eleventh stop portion; 31192: twelfth stop portion; 31020: third shaft; 310201: thirteenth stop portion;
310202: third limiting structure; 31021: third fastening bracket; 31022: fourth fastening bracket; 310221: fourteenth stop portion;
310222: sixth cam surface; 31023: third cam member; 310231: fifth cam surface; 31024: third elastic component; 32: main shaft; and
321: main inner shaft; 322: main outer shaft; 2000: host; 21: first magnetic member; 22: rear housing.

### DESCRIPTION OF EMBODIMENTS

To make the objectives, technical solutions, and advantages of this application clearer, the following further describes this application in detail with reference to the accompanying drawings. However, example implementations can be implemented in a plurality of forms, and should not be construed as being limited to the implementations described herein. Identical reference numerals in the accompanying drawings denote identical or similar structures. Therefore, repeated descriptions thereof are omitted. Expressions of locations and directions in embodiments of this application are described by using the accompanying drawings as an example. However, changes may also be made as required, and all the changes fall within the protection scope of this application. The accompanying drawings in embodiments of this application are merely used to illustrate relative location relationships and do not represent an actual scale.

It should be noted that details are set forth in the following descriptions for ease of understanding this application. However, this application can be implemented in a plurality of manners different from those described herein, and a person skilled in the art can perform similar promotion without departing from the connotation of this application. Therefore, this application is not limited to the specific implementations disclosed below.

To facilitate understanding of an accessory apparatus provided in this application, the following first describes an application scenario of the accessory apparatus. The accessory apparatus provided in embodiments of this application may be used in but is not limited to a mobile phone, a calculator, a tablet computer used as a light office, a personal digital assistant (personal digital assistant, PDA), or the like.

In this application, the accessory apparatus may be configured to support a host of an electronic device. It may be understood that, when the electronic device supported by the accessory apparatus is opened to be in a use state, the accessory apparatus may form a triangular support area, and a center of gravity of the host of the electronic device falls within the triangular support area, so that the accessory apparatus supports the host of the electronic device.

It may be understood that, usually, to improve an opening feel and support stability of the electronic device, a damping structure is usually disposed in the accessory apparatus, to generate, in a process of opening the accessory apparatus along with the electronic device, torque that hinders movement of the accessory apparatus. However, in a current design, the damping structure in the accessory apparatus generates constant torque in the process of opening the accessory apparatus. If the torque is large, the accessory apparatus can be opened only by using a large opening force. This affects user experience.

In view of this, in the accessory apparatus provided in this application, a rotating shaft mechanism is properly designed, to achieve variable torque in a process of opening the accessory apparatus, thereby improving convenience of opening the accessory apparatus and improving user experience. To facilitate understanding of the accessory apparatus provided in this application, the following describes the accessory apparatus in detail with reference to specific embodiments.

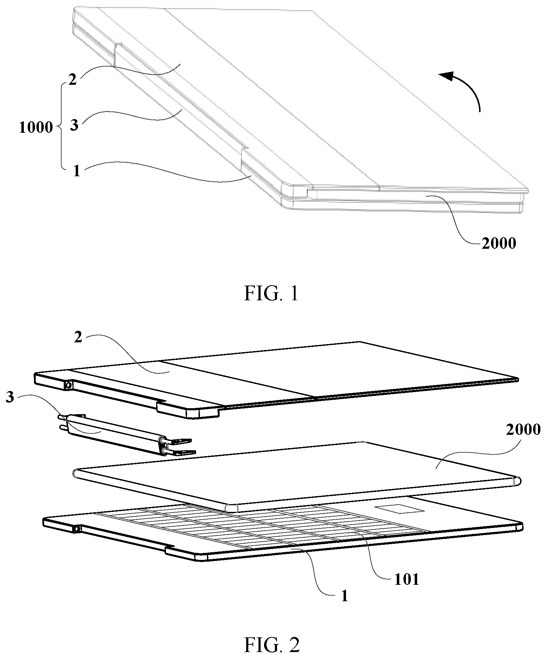

FIG. 1 is a diagram of an application scenario of an accessory apparatus according to an embodiment of this application. This embodiment shows a structure in which an electronic device in which an accessory apparatus 1000 is used is in a closed state. The electronic device includes the accessory apparatus 1000 and a host 2000. The accessory apparatus 1000 includes a body 1 and a support component 2. In a closed state shown in FIG. 1, the body 1 and the support component 2 are disposed opposite to each other, and the host 2000 is located between the body 1 and the support component 2.

It should be noted that in this application, the accessory apparatus 1000 may be an apparatus with a keyboard. In this case, FIG. 2 is an exploded view of the electronic device shown in FIG. 1. The body 1 includes a plurality of buttons 101, and a user may implement an input function of the accessory apparatus 1000 by tapping the buttons 101.

It may be understood that, when the electronic device is in the closed state shown in FIG. 1, the accessory apparatus 1000 may further protect the host 2000. When the electronic device needs to be used, the user may open the electronic device in a direction of an arrow shown in FIG. 1.

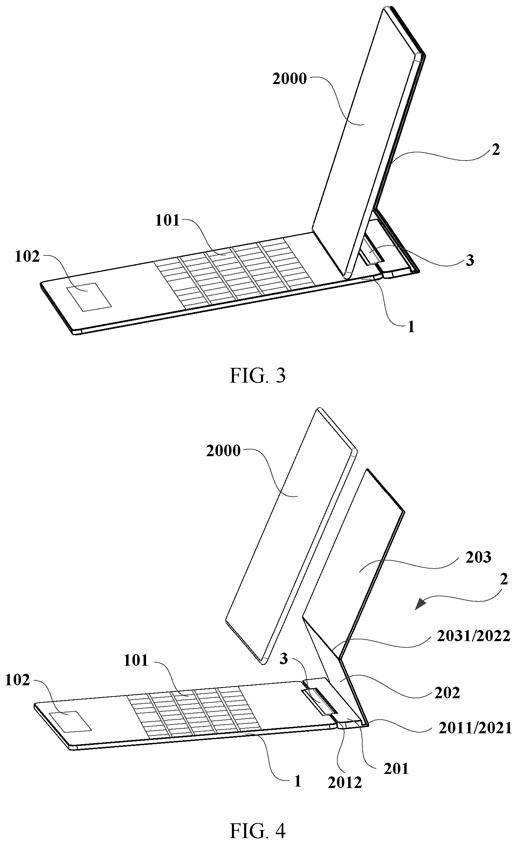

FIG. 3 is a diagram of a structure in which the electronic device is in the open state as shown in FIG. 1. In this application, the support component 2 is connected to an end portion of the body 1, and the support component 2 is rotatably connected to the end portion of the body 1. In addition, the support component 2 may be connected to the host 2000 of the electronic device. In a process in which the electronic device changes from the closed state shown in FIG. 1 to the open state shown in FIG. 3, the host 2000 drives the support component 2 to rotate around the end portion of the body 1, to implement back-to-back motion between the support component 2 and the body 1. When the electronic device is opened to be in a use state, the support component 2 may support the host 2000. In addition, a display of the host 2000 may be configured to display content entered by using the button 101 of the body 1.

As shown in FIG. 3, the body 1 may further include a touch panel 102, and the user may implement a touch operation on the electronic device through the touch panel 102. In addition, a control circuit, a battery, or some sensors (for example, an infrared sensor, an ultrasonic sensor, or a fingerprint sensor) may be further disposed in the body 1. The control circuit may be disposed to provide a circuit control function for the body 1, and the sensor may be disposed to provide a function such as signal triggering. In addition, the battery in the body 1 may be configured to maintain a normal operating state of the body 1 when there is no external power supply.

In some other possible embodiments of this application, the body 1 of the accessory apparatus 1000 may alternatively not have structures such as the button 101 and the touch panel 102, and the body 1 mainly plays protection and support roles.

In this application, to support the host 2000 by the accessory apparatus 1000, the support component 2 may include a plurality of connected support plates. For example, FIG. 4 is an exploded view of the electronic device shown in FIG. 3. The support component 2 includes a first support plate 201, a second support plate 202, and a third support plate 203. The second support plate 202 is located between the third support plate 203 and the first support plate 201. The first support plate 201 includes a first plate edge 2011 and a second plate edge 2012 that are disposed back to back, the second support plate 202 includes a third plate edge 2021 and a fourth plate edge 2022 that are disposed back to back, and the third support plate 203 includes a fifth plate edge 2031. In this case, the first plate edge 2011 is rotatably connected to the third plate edge 2021, to implement a rotatable connection between the first support plate 201 and the second support plate 202. The fifth plate edge 2031 is rotatably connected to the fourth plate edge 2022, to implement a rotatable connection between the second support plate 202 and the third support plate 203. In addition, the second plate edge 2012 is rotatably connected to an end portion of the body 1, to implement a rotatable connection between the first support plate 201 and the body 1, and further implement a rotatable connection between the support component 2 and the body 1.

In this application, the third support plate 203 may be detachably connected to the host 2000. The third support plate 203 may be connected to the host 2000 in a plurality of manners. For example, the third support plate 203 may be connected to the host 2000 through magnetic attachment, snap-fitting, or the like. Examples are not listed one by one herein, but it should be understood that this falls within the protection scope of this application.

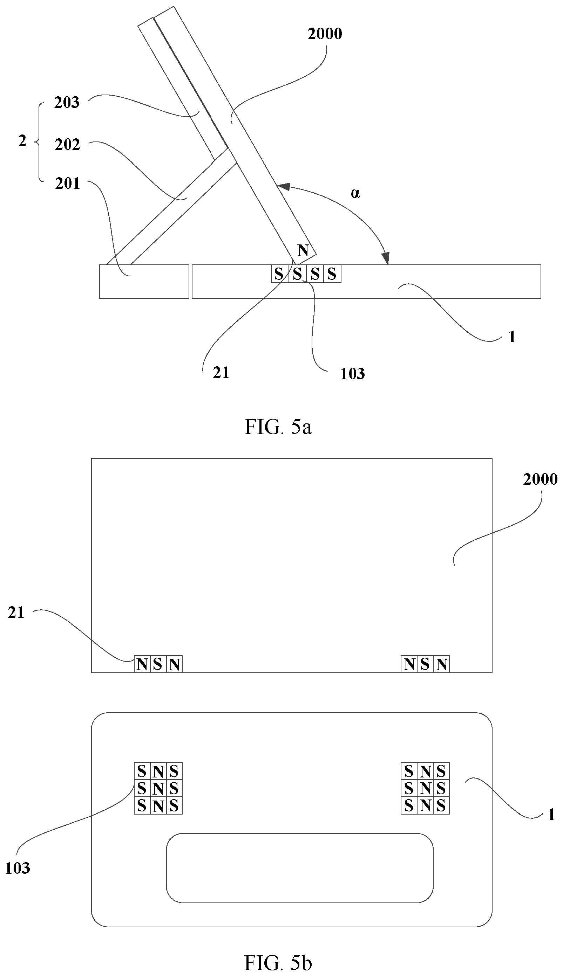

It may be understood that, to form a stable triangular support structure or an approximately triangular support structure between the accessory apparatus 1000 and the host 2000 when the electronic device is in the open state, it is further required that there is no relative motion between the host 2000 and the keyboard body 1 of the accessory apparatus 1000 in the open state. Based on this, FIG. 5a is a simple diagram of a structure of the electronic device shown in FIG. 3. The host 2000 includes a first magnetic member 21, and the first magnetic member 21 is located at an end portion of the host 2000. In addition, FIG. 5b is a simple diagram of a structure of the electronic device shown in FIG. 5a from another perspective. The body 1 further includes a second magnetic member 103, and the first magnetic member 21 and the second magnetic member 103 adsorb each other. In this way, when the electronic device is in the open state, the first magnetic member 21 and the second magnetic member 103 adsorb each other, and an outer surface that is of the first support plate 201 and that is away from the host 2000 is coplanar or approximately coplanar with an outer surface that is of the body 1 and that is away from the host 2000. In this case, a triangular support structure or an approximately triangular support structure is formed in a structure in which the host 2000, the second support plate 202, the first support plate 201, and the body 1 are connected. In this case, the host 2000 may stably stay at such an opening angle.

In this application, the opening angle of the electronic device may be understood as an included angle that is between the host 2000 and the body 1 and that is away from the support component 2, for example, an included angle α shown in FIG. 5a. It may be understood that, in this application, a staying angle of the host 2000 in an open state may be adjusted by adjusting a disposition location of the second magnetic member 103. Still as shown in FIG. 5a and FIG. 5b, in this embodiment of this application, the body 1 may include a plurality of second magnetic members 103 that are sequentially disposed away from the first support plate 201 of the support component 2. In this way, a spacing between the plurality of second magnetic members 103 may be adjusted, so that the host 2000 can stay at a corresponding opening angle when the first magnetic member 21 of the host 2000 and the second magnetic members 103 of the body 1 that are disposed at different locations adsorb each other. For example, in FIG. 3, the opening angle of the electronic device is 120°. In some other possible embodiments of this application, a disposition location of the second magnetic member 103 may be adjusted, so that the opening angle of the electronic device is 125°, 175°, or the like. Details are not described herein, but it should be understood that this falls within the protection scope of this application.

In this application, the host 2000 is connected to the body 1 through magnetic attachment, which helps implement stepless adjustment of the opening angle of the host 2000. Therefore, a use requirement of the user at different opening angles can be met, thereby improving user experience, and improving product competitiveness of the electronic device.

However, in some other possible embodiments of this application, a location of the host 2000 on the body 1 may be further adjusted by disposing a protruding snap-fitting location or a concave snap-fitting location on the body 1. This implements stepless adjustment of the opening angle of the electronic device. Details are not described herein, but it should be understood that this falls within the protection scope of this application.

It may be understood that, in this embodiment of this application, in a process of opening the electronic device, the host 2000 drives the third support plate 203 to rotate in a direction away from the body 1, the third support plate 203 drives the second support plate 202 to rotate in a direction away from the body 1, and the second support plate 202 drives the first support plate 201 to rotate in a direction away from the body 1. When the host 2000 is opened to a specified opening angle, the first magnetic member 21 of the host 2000 and the second magnetic member 103 at a corresponding location of the body 1 adsorb each other, so that the host 2000 can stably stay at a corresponding opening angle. A process of closing the electronic device is an inverse process of the foregoing opening process. Details are not described herein again.

It can be understood from the foregoing descriptions of the principle of supporting the host 2000 by the support component 2 of the accessory apparatus 1000 provided in this embodiment of this application and the opening process and the closing process of the electronic device in which the accessory apparatus 1000 provided in this application is used that, a motion trajectory of each support plate of the support component 2 of the accessory apparatus 1000 plays a key role in whether the electronic device can be opened smoothly and whether the host 2000 can stably stay at the specified opening angle. An implementation of rotation between the first support plate 201 and the body 1 has important impact on rotation of the entire support component 2 relative to the body 1. Based on this, the following specifically describes, based on a specific application scenario, an implementation of a rotatable connection between the first support plate 201 of the accessory apparatus 1000 and the body 1 provided in this embodiment of this application.

In this embodiment of this application, as shown in FIG. 1 to FIG. 4, the accessory apparatus 1000 further includes a rotating module 3. The first support plate 201 is rotatably connected to the rotating module 3, and the body 1 is rotatably connected to the rotating module 3, so that the first support plate 201 is rotatably connected to the body 1. It may be understood that a process in which the first support plate 201 and the body 1 rotate around the rotating module 3 is a process in which the support component 2 and the body 1 move toward or away from each other.

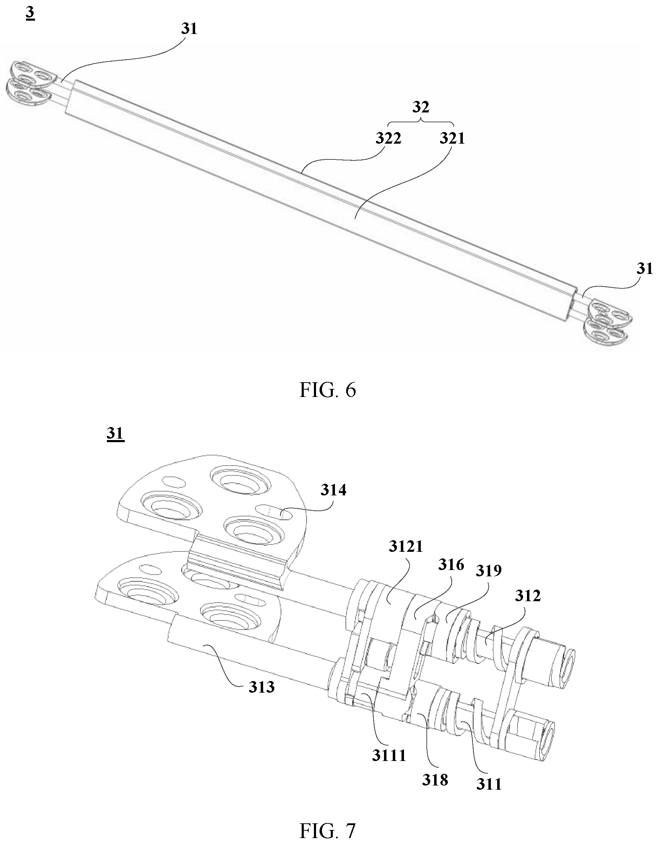

When the rotating module 3 is specifically disposed, FIG. 6 is a diagram of a structure of a rotating module according to an embodiment of this application. The rotating module 3 includes a rotating shaft assembly 31 and a main shaft 32. The main shaft 32 may serve as a bearing structure of the rotating shaft assembly. The main shaft 32 may include a main inner shaft 321 and a main outer shaft 322. The main inner shaft 321 and the main outer shaft 322 are snap-fitted, to form accommodation space. A part of the rotating shaft assembly 31 is installed in the accommodation space between the main inner shaft 321 and the main outer shaft 322.

In this application, the first support plate 201 and the body 1 may be rotatably connected through the rotating shaft assembly 31. To improve reliability of a rotatable connection between the first support plate 201 and the body 1, the rotating module 3 may include a plurality of rotating shaft assemblies 31. For example, the rotating module 3 shown in FIG. 6 includes two rotating shaft assemblies 31, and along an axial direction of the rotating module 3, the two rotating shaft assemblies 31 are respectively located at two end portions of the main shaft 32 that are disposed opposite to each other.

It may be understood that, in some other possible embodiments of this application, the rotating module 3 may further include only one rotating shaft assembly 31. In this way, reliability of the rotatable connection between the first support plate 201 and the body 1 through the rotating module 3 may be ensured through a multipoint connection between the rotating shaft assembly 31 and each of the first support plate 201 and the body 1.

FIG. 7 is a diagram of a structure of a rotating shaft assembly according to an embodiment of this application. FIG. 7 shows a state of the rotating shaft assembly when the electronic device is in the closed state. The rotating shaft assembly 31 includes a first shaft 311 and a second shaft 312. In this application, an axis of the first shaft 311 and an axis of the second shaft 312 are parallel and do not overlap, and an axial direction of the first shaft 311, an axial direction of the second shaft 312, an axial direction of the rotating shaft assembly 31, and the axial direction of the rotating module 3 are the same.

Still as shown in FIG. 7, the rotating shaft assembly further includes a first fastening bracket 313 and a second fastening bracket 314, the first fastening bracket 313 is disposed at an end portion of the first shaft 311, and the first fastening bracket 313 is configured to drive the first shaft 311 to rotate. Similarly, the second fastening bracket 314 is disposed at an end portion of the second shaft 312, and the second fastening bracket 314 is configured to drive the second shaft 312 to rotate. Based on this, it may be understood that the first fastening bracket 313 may be fastened to the second plate edge 2012 of the first support plate 201, and the second fastening bracket 314 may be fastened to an end portion of the body 1, so that in a process in which the support component 2 rotates relative to the body 1, the first shaft 311 and the second shaft 312 of the rotating shaft assembly 31 can be driven to rotate.

A specific connection manner between the first fastening bracket 313 and the first shaft 311 is not limited in this application. In a possible embodiment, the first fastening bracket 313 is connected to the first shaft 311 through a detachable connection. For example, an end portion that is of the first fastening bracket 313 and that faces the first shaft 311 includes an insertion portion, and an end portion of the first shaft 311 includes an insertion slot. In this way, relative motion between the first fastening bracket 313 and the first shaft 311 in a rotation direction may be limited through snap-fitting between the insertion portion and the insertion slot. Similarly, the second fastening bracket 314 and the second shaft 312 may also be detachably connected through snap-fitting, to limit relative motion between the second fastening bracket 314 and the second shaft 312 in the rotation direction.

In this application, when a relative location between the first fastening bracket 313 and the first shaft 311 and a relative location between the second fastening bracket 314 and the second shaft 312 in the rotation direction are fastened through a detachable connection, in an assembly process of the accessory apparatus 1000, the first fastening bracket 313 may be fastened to the first support plate 201, and the second fastening bracket 314 may be fastened to the body 1; and then, the first fastening bracket 313 and the second fastening bracket 314 are snap-fitted to corresponding shafts. This helps improve flexibility of assembling the first support plate 201 and the body 1.

It should be noted that, in this application, the relative location between the first fastening bracket 313 and the first shaft 311 and the relative location between the second fastening bracket 314 and the second shaft 312 in the rotation direction may be fastened in another possible manner. For example, the first fastening bracket 313 and the first shaft 311 may be of an integral structure, and the second fastening bracket 314 and the second shaft 312 may be of an integral structure, which helps simplify a structure of the rotating shaft assembly 31.

The foregoing merely describes some examples of a connection manner between the first fastening bracket 313 and the first shaft 311 and a connection manner between the second fastening bracket 314 and the second shaft 312 in this application. Based on this, the first fastening bracket 313 and the first shaft 311 may be connected in any another possible manner, and the second fastening bracket 314 and the second shaft 312 may be connected in any another possible manner. Details are not described one by one herein, but it should be understood that this falls within the protection scope of this application.

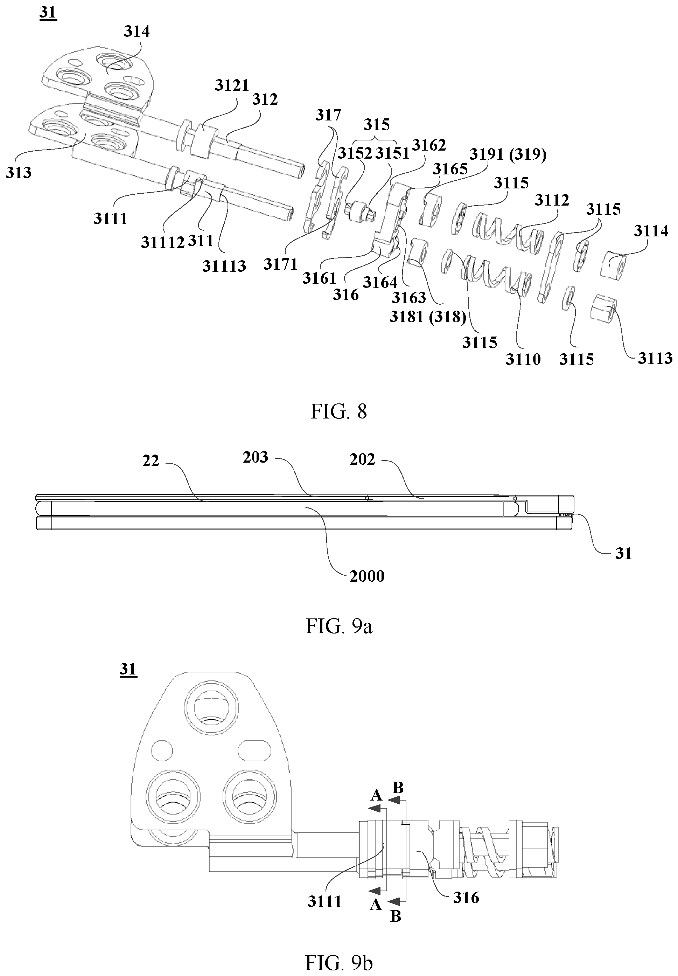

FIG. 8 is an exploded view of the rotating shaft assembly shown in FIG. 7. The first shaft 311 further includes a first rotating wheel 3111, the first rotating wheel 3111 and the first shaft 311 are coaxially disposed, and in the rotation direction of the first shaft 311, a relative location between the first rotating wheel 3111 and the first shaft 311 is fastened. The second shaft 312 further includes a second rotating wheel 3121, the second rotating wheel 3121 and the second shaft 312 are coaxially disposed, and in the rotation direction of the second shaft 312, a relative location between the second rotating wheel 3121 and the second shaft 312 is fastened.

It should be noted that, in this application, the first rotating wheel 3111 and the first shaft 311 may be of an integral structure. In other words, the first rotating wheel 3111 is a partial structure of the first shaft 311. This helps reduce a size of the rotating shaft assembly 31. Similarly, the second rotating wheel 3121 and the second shaft 312 may also be of an integral structure. In other words, the second rotating wheel 3121 is a partial structure of the second shaft 312. In this way, the size of the rotating shaft assembly 31 is reduced.

In some other possible embodiments, the first rotating wheel 3111 and the first shaft 311 may alternatively be of a split structure. In other words, the first rotating wheel 3111 is sleeved on the first shaft 311. In this way, disposition flexibility and maintainability of the rotating shaft assembly 31 can be improved. Similarly, the second rotating wheel 3121 and the second shaft 312 may also be designed in a split manner. In other words, the second rotating wheel 3121 is sleeved on the second shaft 312. In this way, disposition flexibility and maintainability of the rotating shaft assembly 31 are improved.

Still as shown in FIG. 8, the rotating shaft assembly 31 further includes a transfer wheel 315, and the transfer wheel 315 is located between the first rotating wheel 3111 and the second rotating wheel 3121. In addition, FIG. 9a is a side view of the electronic device shown in FIG. 1, namely, a side view in which the electronic device is in the closed state. In the closed state, both the second support plate 202 and the third support plate 203 are attached to a rear housing 22 of the host 2000.

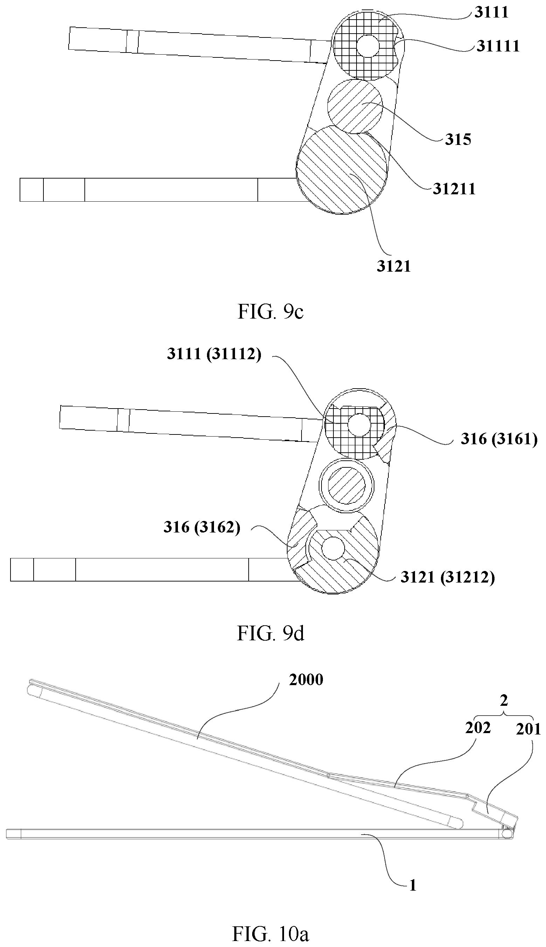

FIG. 9b is a side view of a rotating shaft assembly when an electronic device is in the state shown in FIG. 9a. Still, FIG. 9c is a sectional view along A-A of the rotating shaft assembly shown in FIG. 9b. FIG. 9c is used to show a relative location relationship and a fitting relationship between the transfer wheel 315 and each of the first rotating wheel 3111 and the second rotating wheel 3121 when the electronic device is in the closed state. Specifically, a peripheral side surface of the first rotating wheel 3111 includes a first groove 31111, and a peripheral side surface of the second rotating wheel 3121 includes a second groove 31211. In addition, in the closed state, the first groove 31111 and the second groove 31211 are staggered along an arrangement direction of the first shaft 311, the transfer wheel 315, and the second shaft 312. In addition, a part of the transfer wheel 315 is accommodated in the second groove 31211, and a part of a peripheral side surface of the transfer wheel 315 is in contact with a part that is of the peripheral side surface of the first rotating wheel 3111 and that is located outside the first groove 31111, to press the transfer wheel 315 into the second groove 31211 through the first rotating wheel 3111, so that rotation of the second rotating wheel 3121 is limited through the transfer wheel 315. In this case, in an initial stage of changing from the closed state to the open state by the electronic device, only the first rotating wheel 3111 may rotate relative to the transfer wheel 315. In addition, in the rotation direction of the first shaft 311, the relative location between the first rotating wheel 3111 and the first shaft 311 is fastened. That is, in the initial stage of changing from the closed state to the open state by the electronic device, the first shaft 311 may rotate relative to the second shaft 312, but the second shaft 312 does not move.

FIG. 10a is a side view in which an electronic device is opened to a specified angle according to an embodiment of this application. It can be learned through a comparison that, in a process in which the electronic device is opened from being in the closed state shown in FIG. 9a to being in a state shown in FIG. 10a, the host 2000 of the electronic device rotates around a fastened contact point between the end portion of the host 2000 and the body 1, and the first support plate 201 and the second support plate 202 are raised in a direction away from the body 1, so that the second support plate 202 is separated from the host 2000.

It should be noted that the specified angle at which the electronic device shown in FIG. 10a is opened is not limited in this application. For example, the specified angle may be 25°, 30°, or the like, and may be specifically selected based on a specific design requirement.

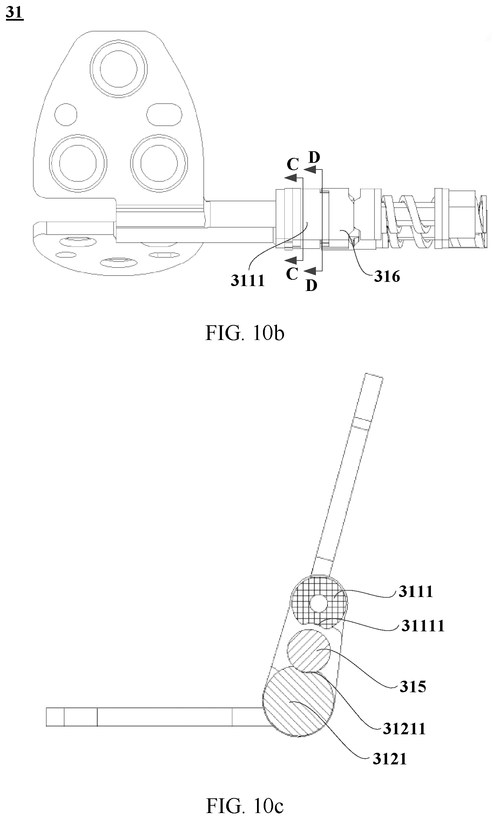

FIG. 10b is a side view of a rotating shaft assembly when an electronic device is in the state shown in FIG. 10a. Still, FIG. 10c is a sectional view along C-C of the rotating shaft assembly shown in 10b. In a state shown in FIG. 10c, the first shaft 311 stops rotating around the axis, and a groove opening of the first groove 31111 faces the transfer wheel 315. In this case, there is a clearance between the first groove 31111 and the transfer wheel 315, so that the transfer wheel 315 has a trend of moving toward the first groove 31111.

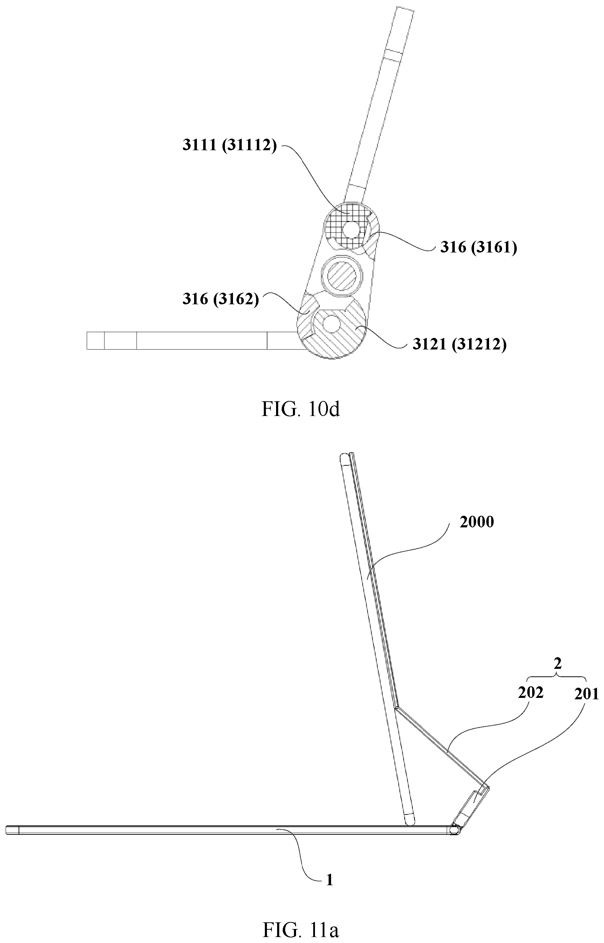

In this case, when a rotating force continues to be applied to the first shaft 311 in the state shown in FIG. 10c, the transfer wheel 315 may be pushed by the first rotating wheel 3111 to move from the second groove 31211 to a part that is of the peripheral side surface of the second rotating wheel 3121 and that is located outside the second groove 31211. In addition, an end portion that is of the host 2000 and that is used to be in contact with the body 1 moves in a direction away from the support component 2, and an included angle between the host 2000 and the second support plate 202 increases. In this way, the electronic device presents a state shown in FIG. 11a.

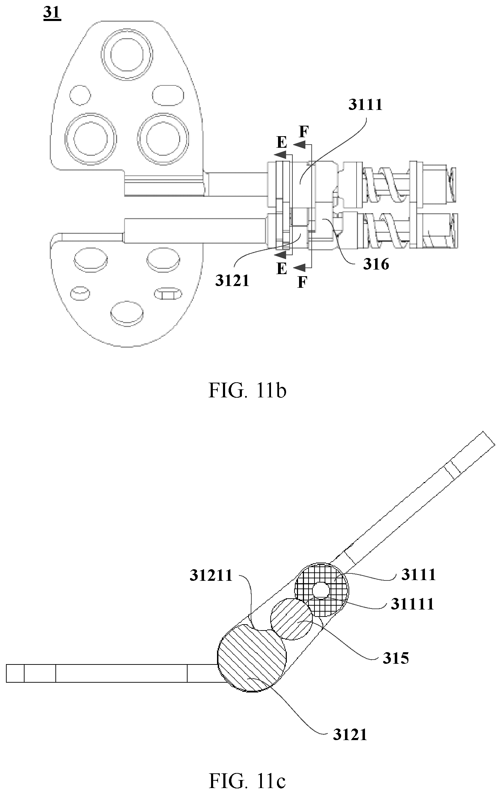

FIG. 11b is a side view of a rotating shaft assembly when an electronic device is in the state shown in FIG. 11a. Still, FIG. 11c is a sectional view along E-E of the rotating shaft assembly shown in FIG. 11b. It may be understood that, after the transfer wheel 315 moves, rotation of the second shaft 312 is no longer limited, so that the second shaft 312 and the second rotating wheel 3121 disposed on the second shaft 312 rotate around the axis, to gradually press the transfer wheel 315 toward the first groove 31111. In this way, at least a part of the transfer wheel 315 can be accommodated in the first groove 31111.

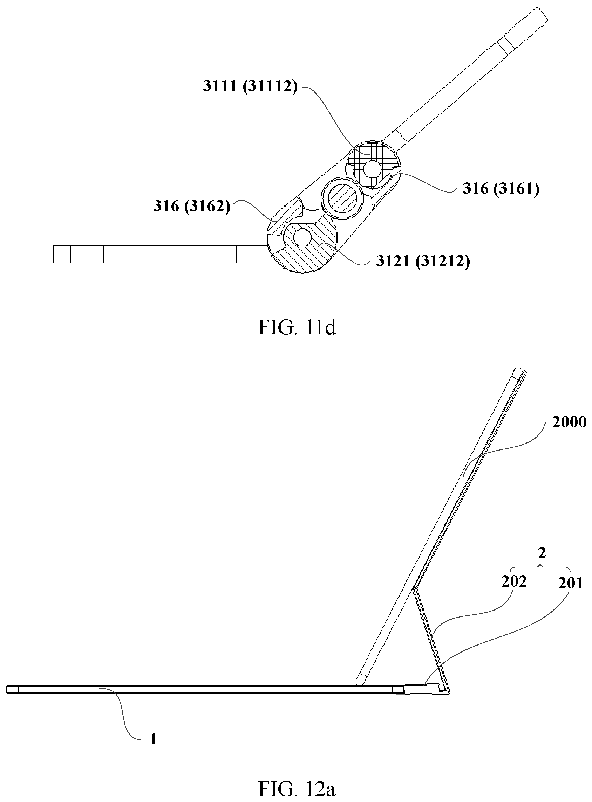

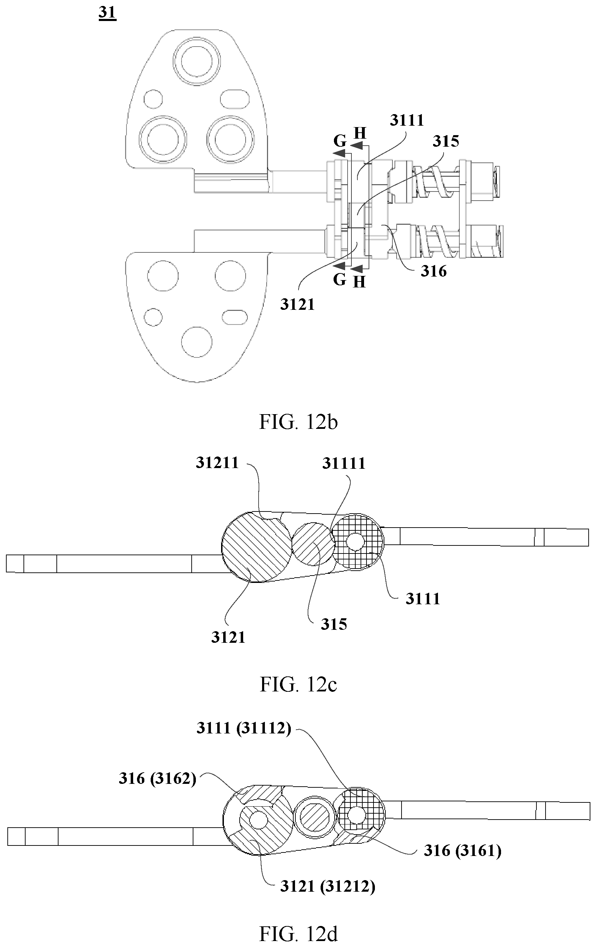

When the electronic device is in the open state, FIG. 12a is a side view in which an electronic device is in an open state according to an embodiment of this application. FIG. 12b is a side view of a rotating shaft assembly when an electronic device is in the state shown in FIG. 12a. Still, FIG. 12c is a sectional view along G-G of the rotating shaft assembly shown in FIG. 12b. In a state shown in FIG. 12c, a part of the transfer wheel 315 is accommodated in the first groove 31111, and a part of a peripheral side surface of the transfer wheel 315 is in contact with the part that is of the peripheral side surface of the second rotating wheel 3121 and that is located outside the second groove 31211.

The foregoing mainly describes, with reference to the accompanying drawings, a rotation sequence of the first shaft 311 and the second shaft 312 of the rotating shaft assembly 31 in a process in which the electronic device changes from the closed state to the open state. Based on this, it may be understood that, in a process in which the electronic device changes from the open state to the closed state, a rotation sequence of the first shaft 311 and the second shaft 312 of the rotating shaft assembly 31 is opposite to the foregoing sequence. Details are not described herein again.

In the foregoing embodiment of this application, the transfer wheel 315 is designed, so that sequential movement that the first shaft 311 in the rotating shaft assembly 31 rotates to a specific angle and then the second shaft 312 rotates is implemented in a process in which the electronic device changes from the closed state to the open state. In this way, torque of the rotating shaft assembly 31 in an early stage of an opening process is small, thereby facilitating opening of the entire electronic device. In addition, the torque of the rotating shaft assembly 31 may increase when the second shaft 312 starts to rotate, so that the accessory apparatus 1000 can reliably support the host 2000 when the electronic device is opened to be in the use state.

It should be noted that, in a possible embodiment of this application, the first shaft 311 is connected to the first support plate 201, and the second shaft 312 is connected to the body 1. In another possible embodiment of this application, the first shaft 311 may be connected to the body 1, and the second shaft 312 may be connected to the first support plate 201. The support component 2 can rotate relative to the body 1, to implement opening/closing of the electronic device in which the accessory apparatus 1000 is used.

As mentioned in the foregoing descriptions of the rotating shaft assembly 31, after the first shaft 311 rotates to the specific angle, an opening of the first groove 31111 of the first rotating wheel 3111 faces the transfer wheel 315. To enable the transfer wheel 315 to move toward the first groove 31111, rotation of the first rotating wheel 3111 needs to be stopped, so that the first rotating wheel 3111 does not rotate relative to the transfer wheel 315. Based on this, still as shown in FIG. 8, in this embodiment of this application, the rotating shaft assembly 31 further includes a conjoined cam 316. The conjoined cam 316 is sleeved on the first shaft 311 and the second shaft 312, and along an axial direction of the rotating shaft assembly 31, the first rotating wheel 3111, the second rotating wheel 3121, and the transfer wheel 315 are all located on a same side of the conjoined cam 316.

In addition, the first rotating wheel 3111 includes a first stop portion 31112, and the first stop portion 31112 is disposed toward the conjoined cam 316. The conjoined cam 316 includes a second stop portion 3161, the second stop portion 3161 is disposed toward the first rotating wheel 3111, and the second stop portion 3161 is located on a motion trajectory along which the first stop portion 31112 rotates around the axis of the first shaft 311. FIG. 9d is a sectional view along B-B of the rotating shaft assembly 31 shown in FIG. 9b. FIG. 9d is used to show a relative location relationship between the first stop portion 31112 of the first rotating wheel 3111 and the second stop portion 3161 of the conjoined cam 316 when the electronic device is in the closed state. It may be understood that, in the closed state, the first stop portion 31112 and the second stop portion 3161 are spaced apart.

In addition, FIG. 10d is a sectional view along D-D of the rotating shaft assembly 31 shown in FIG. 10b. In such a state, the first stop portion 31112 abuts against the second stop portion 3161, and the first shaft 311 stops rotating around the axis. In this case, the opening of the first groove 31111 faces the transfer wheel 315, and the first rotating wheel 3111 stops rotating relative to the transfer wheel 315.

After the first stop portion 31112 abuts against the second stop portion 3161 and the transfer wheel 315 is pressed into the first groove 31111, a rotating force continues to be applied to the first shaft 311, the transfer wheel 315 may be pushed by the first rotating wheel 3111 to move from the second groove 31211 to the part that is of the peripheral side surface of the second rotating wheel 3121 and that is located outside the second groove 31211. FIG. 11d is a sectional view along F-F of the rotating shaft assembly 31 shown in FIG. 11b. FIG. 12d is a sectional view along H-H of the rotating shaft assembly 31 shown in FIG. 12b. It may be understood that, in a process of continuing to open the electronic device after the first stop portion 31112 abuts against the second stop portion 3161, the first stop portion 31112 and the second stop portion 3161 are always in an abutting state, which helps ensure motion stability of the rotating shaft assembly 31.

It should be noted that the second rotating wheel 3121 further includes a third stop portion 31212, and the third stop portion 31212 is disposed toward the conjoined cam 316. The conjoined cam 316 further includes a fourth stop portion 3162, the fourth stop portion 3162 is disposed toward the second rotating wheel 3121, and the fourth stop portion 3162 is located on a motion trajectory along which the third stop portion 31212 rotates around the axis of the second shaft 312. In the closed state shown in FIG. 9d, the third stop portion 31212 abuts against the fourth stop portion 3162. In addition, at the opening angle shown in FIG. 10d, the second shaft 312 does not start to rotate. In this case, the third stop portion 31212 and the fourth stop portion 3162 are still in an abutting state. As shown in FIG. 11d, because the second shaft 312 starts to rotate at this time, the third stop portion 31212 is separated from the fourth stop portion 3162. When the electronic device is in the closed state, as shown in FIG. 12d, the third stop portion 31212 abuts against the fourth stop portion 3162. In this case, the fourth stop portion 3162 stops rotation of the second rotating wheel 3121, so that the second shaft 312 stops moving, and the support component 2 stops rotating relative to the body 1.

In addition, as shown in FIG. 12a, when the electronic device is opened to be in the use state, an included angle, facing the button 101, between an outer surface that is of the first support plate 201 and that is away from the button 101 and an outer surface that is of the body 1 and that is away from the button 101 is approximately 180°, and for example, may be 180°±5°. In other words, when the accessory apparatus 1000 is in the open state, the included angle, facing the button 101, between the outer surface that is of the first support plate 201 and that is away from the button 101 and the outer surface that is of the body 1 and that is away from the button 101 is greater than or equal to 175° and less than or equal to 185°. In this way, the outer surface of the first support plate 201 and the outer surface of the body 1 are approximately coplanar. This can reduce design difficulty of the rotating shaft assembly 31 and meet a support reliability requirement of the support component 2. In this way, the electronic device can be stably maintained in the open state.

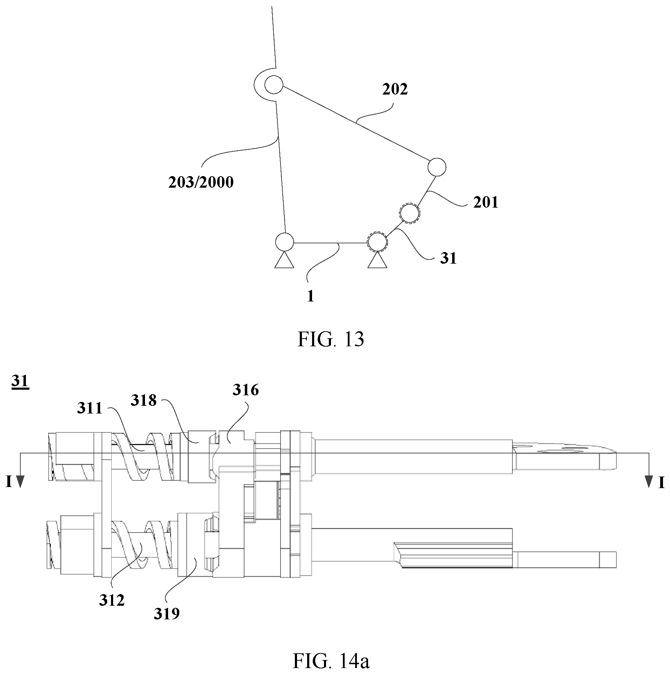

It may be understood from the foregoing descriptions of the opening process of the electronic device that, in the accessory apparatus 1000 provided in this application, the rotating shaft module with a dual-shaft design is used, and a rotation location of the rotating shaft in the rotating shaft assembly 31 is limited by designing a stop structure, so that motion trajectories of the first support plate 201 and the second support plate 202 of the support component 2 can be limited. FIG. 13 is a principle diagram of a motion mechanism of an accessory apparatus in which the rotating shaft assembly provided in the foregoing embodiments is used according to this application. It can be learned from FIG. 13 that, movement of the support component of the accessory apparatus around the body may be equivalent to five-link transmission. The first support plate 201, the second support plate 202, the third support plate 203, the host 2000, the rotating shaft assembly 31, and the body 1 each may be considered as one member. In addition, a kinematic pair between the first support plate 201 and the rotating shaft assembly 31, a kinematic pair between the second support plate 202 and the first support plate 201, a kinematic pair between the second support plate 202 and an entirety of the third support plate 203 and the host 2000, and a kinematic pair between the rotating shaft assembly 31 and the body 1 each are a lower pair. In other words, the five-link transmission mechanism includes four lower pairs. In addition, in a process in which the support component 2 rotates around the body 1, while rotating around respective axes of the rotating shaft assembly 31, the first shaft 311 and the second shaft 312 of the rotating shaft assembly 31 may also serve as an entirety to rotate around the body 1 along with the support component 2. In this case, the rotating shaft assembly 31 may be considered as a higher-pair movement member.

Therefore, degree of freedom of five-link transmission mechanism=3×4-2×5-1=1. Therefore, it can be understood that the degree of freedom of the five-link transmission mechanism is unique. In other words, a motion trajectory of each member of the five-link transmission mechanism is unique. In this case, in the process in which the support component 2 of the accessory apparatus 1000 rotates around the body 1, a rotation trajectory of each support plate and the rotating shaft assembly 31 is unique. In this way, when the electronic device is in the open state, coplanarity between the outer surface of the first support plate 201 and the outer surface of the body 1 can be improved, to improve appearance flatness of the accessory apparatus 1000. In addition, when the accessory apparatus 1000 is in the closed state, a side edge of the accessory apparatus 1000 has no convex structure, and therefore, the appearance flatness of the accessory apparatus 1000 is high. Therefore, in the rotating module 3 of the accessory apparatus 1000 provided in this application, the rotating shaft assembly 31 provided in the foregoing embodiment is used. This can help improve appearance simplicity of the accessory apparatus 1000.

Still as shown in FIG. 8, the conjoined cam 316 further includes a first elongated hole 3163. In addition, the rotating shaft assembly 31 further includes a snap-fit 317, the snap-fit 317 is snap-fitted into the first shaft 311 and the second shaft 312, the snap-fit 317 includes a second elongated hole 3171, and the second elongated hole 3171 and the first elongated hole 3163 are disposed opposite to each other. The transfer wheel 315 is located between the snap-fit 317 and the conjoined cam 316, and the transfer wheel 315 includes a first guiding portion 3151 and a second guiding portion 3152 that are disposed back to back along an axial direction. The first guiding portion 3151 is inserted into the first elongated hole 3163, the second guiding portion 3152 is inserted into the second elongated hole 3171, the first guiding portion 3151 may slide along the first elongated hole 3163, and the second guiding portion 3152 may slide along the second elongated hole 3171. In this way, detachment of the transfer wheel can be effectively avoided, thereby helping improve structural reliability of the rotating shaft assembly 31.

It may be understood that, in some possible embodiments, when a thickness dimension of the conjoined cam 316 along the axial direction of the rotating shaft assembly 31 is large, the first elongated hole 3163 may also be replaced with a form of a slot. Similarly, when a thickness dimension of the snap-fit 317 along the axial direction of the rotating shaft assembly 31 is large, the second elongated hole 3171 may also be replaced with a form of a slot.

A specific snap-fitting form between the snap-fit 317 and each of the first shaft 311 and the second shaft 312 is not limited in this application. For example, in the embodiment shown in FIG. 8, the rotating shaft assembly 31 includes two snap-fits 317, and each snap-fit 317 includes two hooks with opposite bending directions. In addition, the first shaft 311 and the second shaft 312 each are provided with a snap-fitting slot, and two hooks of each snap-fit 317 are respectively snap-fitted into the snap-fitting slots of the first shaft 311 and the second shaft 312, to implement snap-fitting between each snap-fit 317 and each of the first shaft 311 and the second shaft 312.

It should be noted that, in the embodiment shown in FIG. 8, bending directions of two hooks of the two snap-fits 317 snap-fitted into a snap-fitting slot of the first shaft 311 are opposite, and bending directions of two hooks of the two snap-fits 317 snap-fitted into a snap-fitting slot of the second shaft 312 are opposite. This can effectively improve snap-fitting reliability between the two snap-fits 317 and each of the first shaft 311 and the second shaft 312, and help improve structural reliability of the rotating shaft assembly 31. In addition, in this application, a material of the snap-fit 317 may be but is not limited to rubber, plastic, or the like, and the snap-fit 317 may further serve as an appearance member of the rotating shaft assembly 31, to improve appearance integrity and aesthetics of the rotating shaft assembly 31.

As mentioned in the foregoing descriptions of the rotating shaft assembly 31, the torque of the rotating shaft assembly 31 at the early stage of the opening process is small, which facilitates opening of the entire electronic device; and when the second shaft 312 starts to rotate, the torque of the rotating shaft assembly 31 increases, which helps improve support reliability of the accessory apparatus 1000 for the host 2000. It can be learned that, controlling the torque of the rotating shaft assembly 31 in the rotation process is also a key to improving user experience.

Still as shown in FIG. 8, the rotating shaft assembly 31 further includes a first cam member 318 and a second cam member 319. The first cam member 318 is sleeved on the first shaft 311, and in the rotation direction of the first shaft 311, a relative location between the first cam member 318 and the first shaft 311 is fastened. In other words, the first cam member 318 may rotate synchronously with the first shaft 311. The second cam member 319 is sleeved on the second shaft 312, and in the rotation direction of the second shaft 312, a relative location between the second cam member 319 and the second shaft 312 is fastened. In other words, the second cam member 319 may rotate synchronously with the second shaft 312.

In addition, an end portion that is of the first cam member 318 and that faces the conjoined cam 316 includes a first cam surface 3181, an end portion that is of the second cam member 319 and that faces the conjoined cam 316 includes a second cam surface 3191, an end portion that is of the conjoined cam 316 and that faces the first cam member 318 includes a third cam surface 3164, and an end portion that is of the conjoined cam 316 and that faces the second cam member 319 includes a fourth cam surface 3165.

In this application, the cam surface may include a protrusion portion and a concave portion, and an inclined surface exists in a process of a transition from the protrusion portion to the concave portion or a transition from the concave portion to the protrusion portion. When a protrusion portion of one of the two cam surfaces is in a concave portion of the other cam surface, an extrusion force between the two cam surfaces is small, and a damping force of relative motion between the two cam surfaces is small. When inclined surfaces of the two cam surfaces are in contact with each other, an extrusion force between the two cam surfaces increases, and a damping force of relative motion between the two cam surfaces increases. It can be learned that when protrusion portions of the two cam surfaces are disposed opposite to each other, the extrusion force between the two cam surfaces is the largest, and the damping force of the relative motion between the two cam surfaces is the largest.

Based on this, to enable the first cam surface 3181 and the third cam surface 3164 to abut against each other, and enable the second cam surface 3191 and the fourth cam surface 3165 to abut against each other, still as shown in FIG. 8, the rotating shaft assembly 31 further includes a first elastic component 3110 and a second elastic component 3112, the first elastic component 3110 is sleeved on the first shaft 311, and the first elastic component 3110 may provide an elastic acting force along the axial direction of the first shaft 311. The first cam member 318 is located between the conjoined cam 316 and the first elastic component 3110, and the first elastic component 3110 abuts against an end face that is of the first cam member 318 and that is away from the conjoined cam 316. Therefore, under an elastic acting force of the first elastic component 3110, the first cam surface 3181 of the first cam member 318 may abut against the third cam surface 3164 of the conjoined cam 316.

Similarly, the second elastic component 3112 is sleeved on the second shaft 312, and the second elastic component 3112 may provide an elastic acting force along the axial direction of the second shaft 312. The second cam member 319 is located between the conjoined cam 316 and the second elastic component 3112, and the second elastic component 3112 abuts against an end face that is of the second cam member 319 and that is away from the conjoined cam 316. Therefore, under an elastic acting force of the second elastic component 3112, the second cam surface 3191 of the second cam member 319 may abut against the fourth cam surface 3165 of the conjoined cam 316.

A specific disposition form of the first elastic component 3110 and the second elastic component 3112 is not limited in this application. For example, the first elastic component 3110 may include a spring, and the second elastic component 3112 may also include a spring, to simplify structures of the first elastic component 3110 and the second elastic component 3112, which facilitates a miniaturization design of the rotating shaft assembly 31.

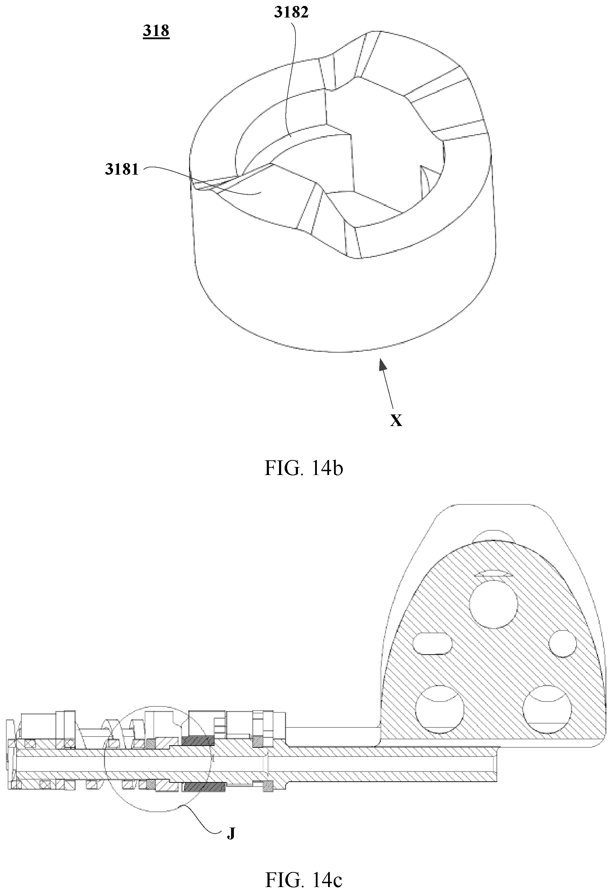

FIG. 14a is a diagram of a structure of the rotating shaft assembly 31 shown in FIG. 9b from another perspective. In other words, FIG. 14a shows a diagram of a structure of the rotating shaft assembly 31 in a closed state shown in FIG. 14a from another perspective. In addition, FIG. 14b is a diagram of a structure of a first cam member according to an embodiment of this application. It can be learned from FIG. 14b that a step surface 3182 is further disposed in a shaft hole of the first cam member 318. It can be learned from the exploded view of the rotating shaft assembly 31 shown in FIG. 8 that the first shaft 311 further includes a first limiting structure 31113.

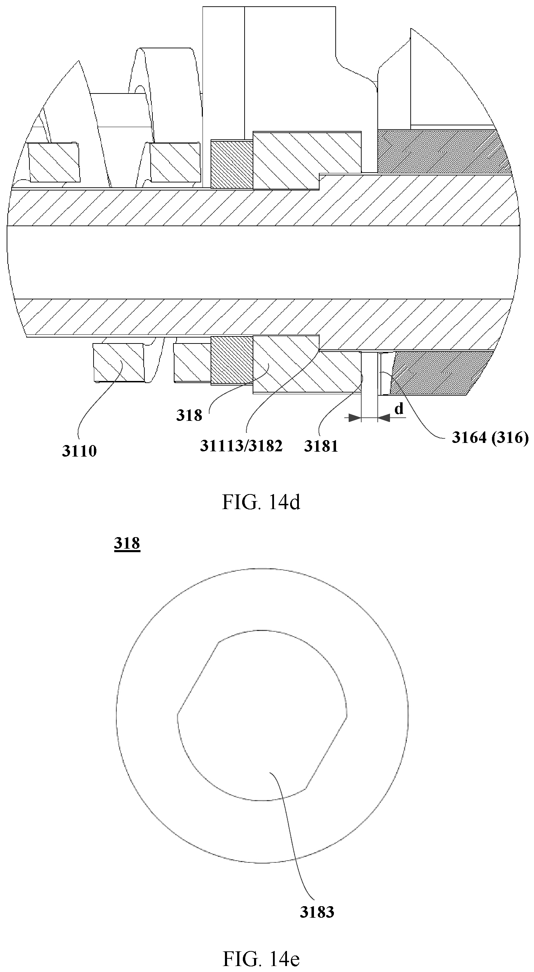

Still, FIG. 14c is a sectional view along I-I of the rotating shaft assembly 31 shown in FIG. 14a. FIG. 14c may be used to show a fitting relationship between the first cam surface 3181 of the first cam member 318 and the third cam surface 3164 of the conjoined cam 316 in the closed state. In addition, FIG. 14d is an enlarged view of a partial structure at a location J of a structure shown in FIG. 14c. It can be learned from FIG. 14d that, in the closed state, the step surface 3182 of the first cam member 318 abuts against an end face of the first limiting structure 31113 along the axial direction of the first shaft 311, so that the first cam member 318 abuts against the end face of the first limiting structure 31113 along the axial direction of the first shaft 311, and there is a clearance fit between the first cam surface 3181 and the third cam surface 3164. A clearance between the first cam surface 3181 and the third cam surface 3164 may be represented by d in FIG. 14c. In actual applications, the first shaft 311 may be a stepped shaft, and the first limiting structure 31113 is a step surface of the stepped shaft.

When the first cam member 318 abuts against the first limiting structure 31113, the elastic acting force of the first elastic component 3110 cannot be transferred to the conjoined cam 316 through the first cam member 318. Therefore, in the process of changing from the closed state to the open state, the first shaft 311 undergoes small torque duration rotation. This can facilitate opening of the entire electronic device.

FIG. 14e is an X-direction view of the first cam member 318 shown in FIG. 14b. It can be learned from FIG. 14e that, in this application, the shaft hole 3183 of the first cam member 318 may be a non-circular hole. Therefore, when the first cam member 318 is sleeved on the first shaft 311, a direction in which the first cam member 318 and the first shaft 311 rotate around the axis may be relatively fastened, and the first cam member 318 may rotate synchronously with the first shaft 311.

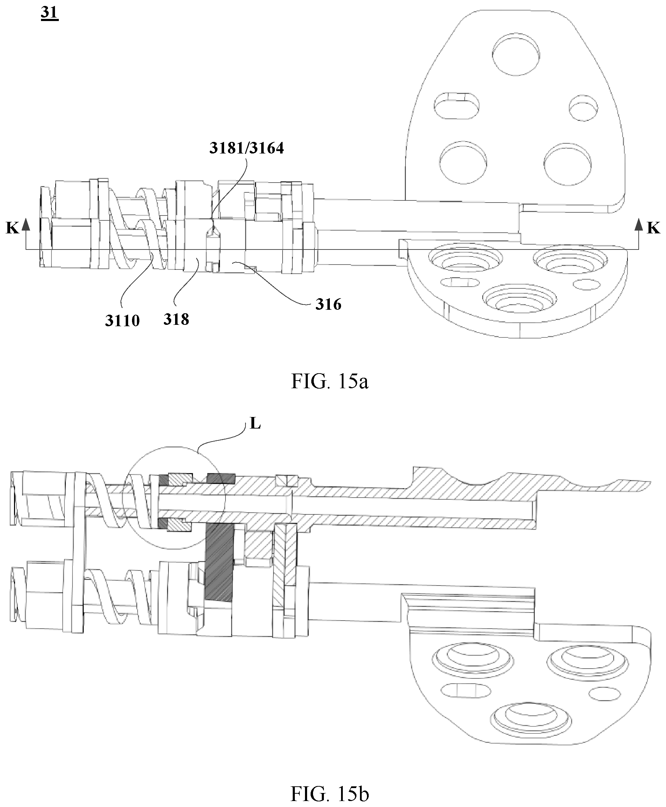

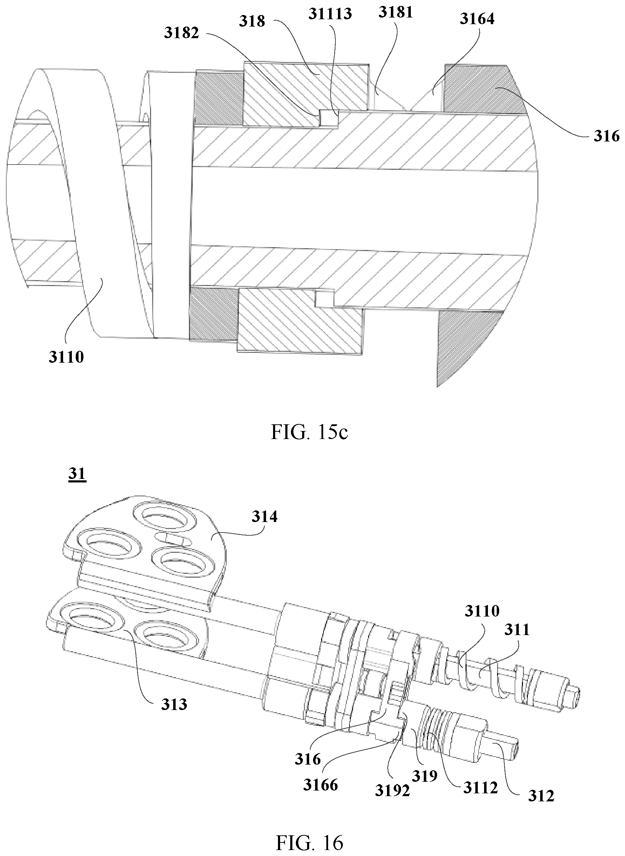

In addition, as shown in FIG. 14a, because the conjoined cam 316 is sleeved on both the first shaft 311 and the second shaft 312, a relative location between the first cam surface 3181 and the third cam surface 3164 changes as the first shaft 311 rotates. Specifically, FIG. 15a is a diagram of a structure of the rotating shaft assembly 31 shown in FIG. 10b from another perspective. Still, FIG. 15b is a sectional view along K-K of the rotating shaft assembly 31 shown in FIG. 15a. FIG. 15b may be used to show a fitting relationship between the first cam surface 3181 of the first cam member 318 and the third cam surface 3164 of the conjoined cam 316 at a specified angle. In addition, FIG. 15c is an enlarged view of a partial structure at a location L of a structure shown in FIG. 15b. It can be learned from FIG. 15c that, in this state, a protrusion portion of the first cam surface 3181 abuts against a protrusion portion of the third cam surface 3164, and under an extrusion effect of the conjoined cam 316, the step surface 3182 of the first cam member 318 is separated from the first limiting structure 31113. In this case, if the first elastic component 3110 is compressed, the elastic acting force of the first elastic component 3110 is transferred to the conjoined cam 316 through the first cam member 318, so that torque undergone by the first shaft 311 through rotation increases. In this way, when the electronic device is opened to be in the use state, a risk that the entire device shakes due to loosening of the first shaft 311 can be effectively reduced, thereby improving stability of using the electronic device and improving user experience.

It should be noted that the foregoing solution in which the stepped shaft limits the first cam member 318 to implement a torque change of the first shaft 311 in the rotation process is merely example descriptions provided in this application. Based on this design principle, a series of deformations may be further performed on a specific disposition manner of the limiting structure. For example, there is a clearance fit between the first cam surface 3181 and the third cam surface 3164 at an initial stage of rotation by disposing a protrusion on the first shaft 311. Examples are not listed one by one herein, but it should be understood that this falls within the protection scope of this application.

It may be understood that, in this application, torque of the first shaft 311 in the rotation process is controlled by adding the limiting structure, so that the torque undergone by the first shaft 311 at a specific rotation angle can be effectively removed. In addition, an implementation means is easy to control, and manufacturing costs are low.

In addition, in another possible embodiment of this application, the first shaft 311 may further have variable torque in the rotation process by increasing rigidity of an elastic element, increasing a height difference between the protrusion of the first cam surface 3181 and the protrusion of the third cam surface 3164, or the like. Details are not described herein, but it should be understood that this falls within the protection scope of this application.

Still as shown in FIG. 8, in this application, the rotating shaft assembly 31 may further include a first nut 3113 and a second nut 3114, to avoid detachment of parts installed on the first shaft 311 and the second shaft 312. An end portion that is of the first shaft 311 and that is away from the first fastening bracket 313 has an external thread (not shown in FIG. 8). Therefore, the first nut 3113 is screwed with an external thread of the first shaft 311, to implement a threaded connection between the first nut 3113 and the end portion that is of the first shaft 311 and that is away from the first fastening bracket 313. In this way, when the first nut 3113 limits each structure installed on the first shaft 311, the first elastic component 3110 may be further extruded, so that the first elastic component 3110 accumulates an elastic acting force along the axial direction of the first shaft 311. It may be understood that, in this application, a compression amount of the first elastic component 3110 may be further controlled by adjusting a tightness status of the first nut 3113, to control the elastic acting force accumulated by the first elastic component 3110.

Similarly, an end portion that is of the second shaft 312 and that is away from the second fastening bracket 314 has an external thread (not shown in FIG. 8). Therefore, the second nut 3114 is screwed with an external thread of the second shaft 312, to implement a threaded connection between the second nut 3114 and the end portion that is of the second shaft 312 and that is away from the second fastening bracket 314. In this way, when the second nut 3114 limits each structure installed on the second shaft 312, the second elastic component 3112 may be further extruded, so that the second elastic component 3112 accumulates an elastic acting force along the axial direction of the second shaft 312. Similarly, in this application, a compression amount of the second elastic component 3112 may be further controlled by adjusting a tightness status of the second nut 3114, to control the elastic acting force accumulated by the second elastic component 3112.

The foregoing describes in detail only a part of main components in the rotating shaft assembly 31 provided in this application. In addition, some components may be added, replaced, or removed in the rotating shaft assembly 31 based on a specific use requirement. For example, the first nut 3113 and the second nut 3114 may be alternatively replaced with snap-fits. In addition, as shown in FIG. 8, a gasket 3115 sleeved on the first shaft 311 may be further disposed between the first elastic component 3110 and the first cam member 318 and between the first elastic component 3110 and the first nut 3113. This can effectively reduce a risk of wear between the first cam member 318, the first elastic component 3110, and the first nut 3113. Similarly, a gasket 3115 sleeved on the second shaft 312 may also be disposed between the second elastic component 3112 and the second cam member 319 and between the second elastic component 3112 and the second nut 3114, to reduce a risk of wear of the second cam member 319, the second elastic component 3112, and the second nut 3114. It should be noted that the gasket 3115 may be in a split form, to be specific, the gasket 3115 sleeved on the first shaft 311 and the gasket 3115 sleeved on the second shaft 312 are separately disposed; or the gasket 3115 may be in an integral form, to be specific, the gasket 3115 sleeved at a same location of the first shaft 311 and the second shaft 312 may be of an integral structure; or the gasket 3115 sleeved at a same location of the first shaft 311 and the second shaft 312 is a combination of a gasket 3115 in a split form and a gasket 3115 in an integral form.

It should be noted that, in the foregoing embodiments, a specific disposition manner of the rotating shaft assembly 31 is described by using an example in which a shaft diameter of the first shaft 311 is less than a shaft diameter of the second shaft 312. In some other possible embodiments of this application, for example, in the rotating shaft assembly 31 shown in FIG. 16, the shaft diameter of the first shaft 311 and the shaft diameter of the second shaft 312 may alternatively be the same. In another possible embodiment, the shaft diameter of the first shaft 311 of the rotating shaft assembly 31 may alternatively be greater than the shaft diameter of the second shaft 312. In other words, in this application, the shaft diameters of the two shafts of the rotating shaft assembly 31 are not limited, and may be adjusted based on a specific design requirement such as a volume of the rotating shaft assembly 31.

In addition, in the rotating shaft assembly 31 shown in FIG. 8, a same design manner is used for components disposed on the first shaft 311 and the second shaft 312. For example, the first elastic component 3110 and the second elastic component 3112 each are a spring, and a length of the first shaft 311 and a length of the second shaft 312 are the same.

In the rotating shaft assembly 31 shown in FIG. 16, the length of the second shaft 312 is shorter than the length of the first shaft 311. In addition, the first elastic component 3110 is a spring, and the second elastic component 3112 is a spring plate. This facilitates variable torque of the first shaft 311 in the rotation process, and can ensure large-torque rotation of the second shaft 312. In addition, in the rotating shaft assembly 31 shown in FIG. 16, the second cam member 319 is not provided with a second cam surface, and the conjoined cam 316 is not provided with a fourth cam surface either. In other words, the second cam member 319 and the conjoined cam 316 do not abut against each other through a cam surface, but are directly in contact through a plane, to ensure that the second shaft 312 has large torque in the entire rotation process.

Still as shown in FIG. 16, the second cam member 319 includes a fifth stop portion 3192, and the fifth stop portion 3192 is disposed toward the conjoined cam 316. The conjoined cam 316 includes a sixth stop portion 3166, the sixth stop portion 3166 is disposed toward the second cam member 319, and the sixth stop portion 3166 is located on a motion trajectory along which the fifth stop portion 3192 rotates around the axis of the second shaft 312. Therefore, when the electronic device is in the closed state, the sixth stop portion 3166 abuts against the fifth stop portion 3192. In this case, the sixth stop portion 3166 stops rotation of the second cam member 319, so that the second shaft 312 stops moving, and the support component 2 stops rotating relative to the body 1.

It may be understood that, in the rotating shaft assembly 31 shown in FIG. 16, a stop location of the fourth stop portion 3162 for the third stop portion 31212 is the same as a stop location of the sixth stop portion 3166 for the fifth stop portion 3192, which helps improve reliability of limiting a rotation location of the second shaft 312, thereby improving support reliability of the accessory apparatus 1000. Specific disposition manners of the rotating shaft assembly 31 in various actual application scenarios are not described one by one herein, but should be understood as falling within the protection scope of this application.

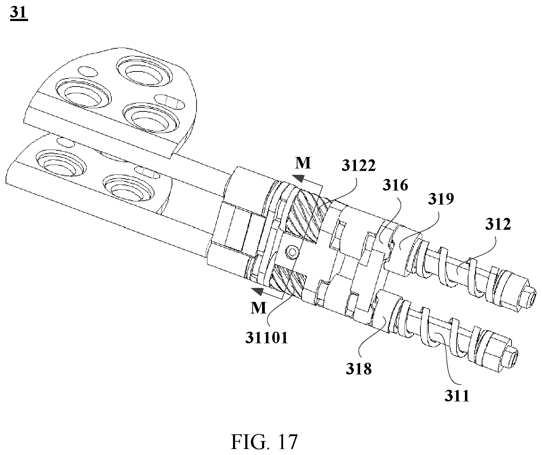

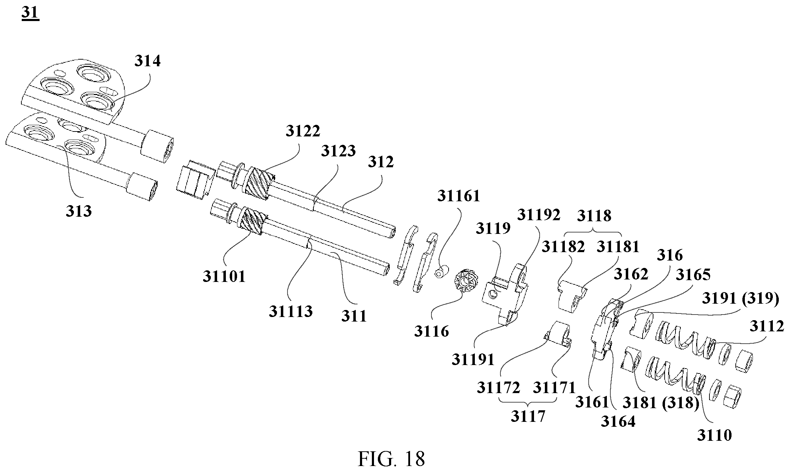

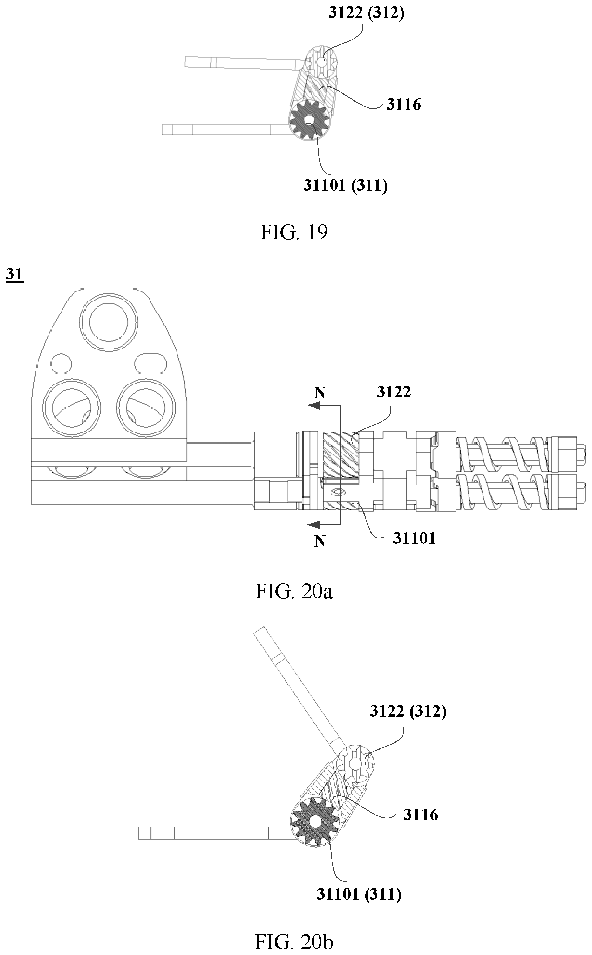

FIG. 17 is a diagram of another structure of a rotating shaft assembly according to an embodiment of this application. Different from the rotating shaft assembly 31 described in the foregoing embodiments, in a movement process of the rotating shaft assembly 31 shown in FIG. 17, the first shaft 311 and the second shaft 312 rotate synchronously. During specific implementation, FIG. 18 is an exploded view of the rotating shaft assembly shown in FIG. 17. The first shaft 311 includes a first helical surface 31101, the second shaft 312 includes a second helical surface 3122, and the first helical surface 31101 and the second helical surface 3122 have a same rotation direction. In addition, FIG. 19 is a sectional view along M-M of the rotating shaft assembly 31 shown in FIG. 17. The rotating shaft assembly 31 further includes an idler gear 3116, the idler gear 3116 is located between the first helical surface 31101 and the second helical surface 3122, the first helical surface 31101 is engaged with a tooth flank of the idler gear 3116, and the second helical surface 3122 is engaged with a tooth flank of the idler gear 3116.

In addition, FIG. 20a is a side view in which the rotating shaft assembly shown in FIG. 17 is opened to a specified angle. Still, FIG. 20b is a sectional view along N-N of the rotating shaft assembly shown in FIG. 20a. It can be learned through a comparison that, in a process in which the rotating shaft assembly 31 changes from the state shown in FIG. 19 to the state shown in FIG. 20a, the first shaft 311 and the second shaft 312 synchronously rotate reversely by a specified angle.

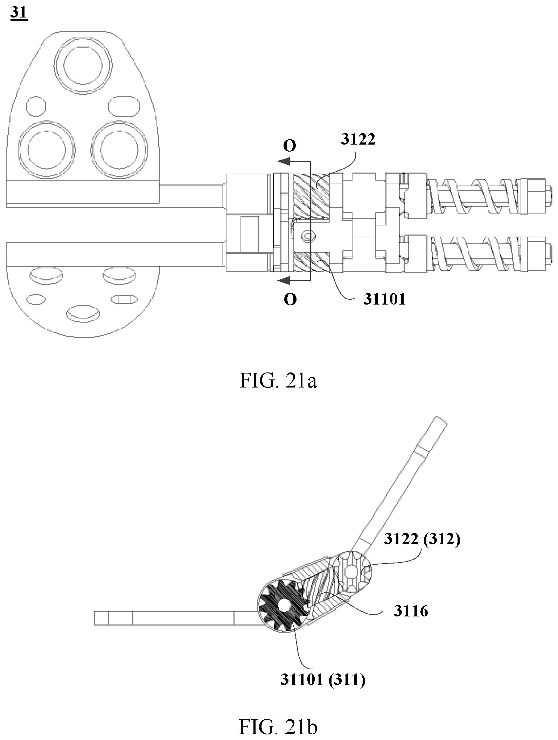

The rotating shaft assembly shown in FIG. 20a continues to be opened, and may present a state shown in FIG. 21a. In addition, FIG. 21b is a sectional view along O-O of the rotating shaft assembly shown in FIG. 21a. In other words, in a process in which the rotating shaft assembly 31 changes from the state shown in FIG. 20a to the state shown in FIG. 21a, the first shaft 311 and the second shaft 312 continue to synchronously rotate reversely.

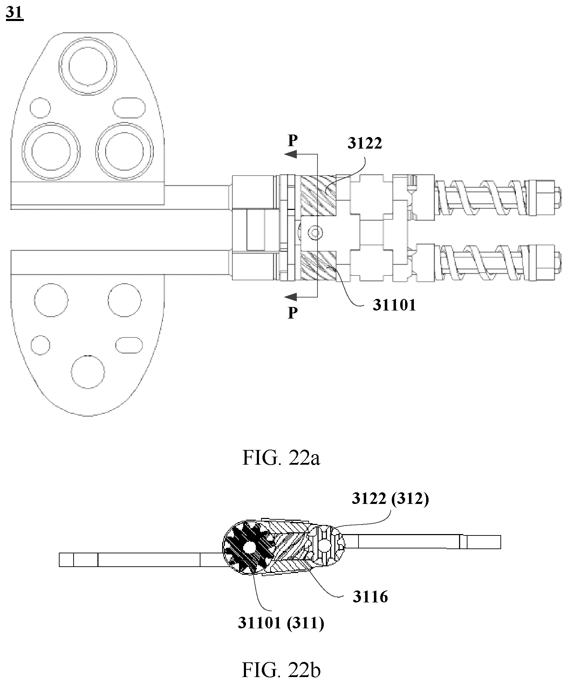

FIG. 22a is a diagram of a structure of a rotating shaft assembly in an open state. In addition, FIG. 22b is a sectional view along P-P of the rotating shaft assembly shown in FIG. 22a. In this case, the first shaft 311 and the second shaft 312 each rotate to a maximum angle.

In conclusion, it may be understood that, in a process in which the rotating shaft assembly 31 changes from the state shown in FIG. 17 to the state shown in FIG. 22a, the first shaft 311 and the second shaft 312 can rotate synchronously and reversely. This helps improve rotation stability of the first shaft 311 and the second shaft 312, thereby improving stability of relative rotation between the first support plate 201 and the body 1.

It should be noted that, in this application, in addition to the foregoing manner in which the first shaft 311 and the second shaft 312 synchronously rotate through fitting between the helical surface and the idler gear 3116, in some other possible embodiments of this application, a tooth flank may be further disposed on the first shaft 311 and the second shaft 312, so that the first shaft 311 and the second shaft 312 synchronously rotate through tooth flank transmission. In addition, it may be understood that, when the first shaft 311 and the second shaft 312 synchronously rotate through tooth flank transmission, the rotating shaft assembly 31 may further include an even quantity of driven gears disposed between the first shaft 311 and the second shaft 312, which may be selected based on a specific design requirement of the rotating shaft assembly 31. However, in some other embodiments, the first shaft 311 and the second shaft 312 may alternatively rotate synchronously in another possible manner, for example, by using a link component. Details are not described herein, but it should be understood that this falls within the protection scope of this application.

It can be learned from the foregoing descriptions that, when the rotating shaft assembly 31 with the dual-shaft design is used in the accessory apparatus 1000 provided in this application, a stop structure may be used to limit a rotation location of a shaft in the rotating shaft assembly 31, to limit the motion trajectories of the first support plate 201 and the second support plate 202 of the support component 2. In this way, it is ensured that each support plate and the rotating shaft assembly 31 have a unique rotation trajectory in a process in which the support component 2 rotates around the body 1, to meet a use requirement of opening the electronic device in one step.

Based on this, in the rotating shaft assembly 31 shown in FIG. 18, the conjoined cam 316 also includes a stop structure. For a specific disposition manner of the conjoined cam 316, refer to the rotating shaft assembly 31 shown in FIG. 8. Details are not described herein again. In addition, still as shown in FIG. 18, the rotating shaft assembly 31 further includes a first stop member 3117 and a second stop member 3118, the first stop member 3117 is sleeved on the first shaft 311, and in the rotation direction of the first shaft 311, a relative location between the first stop member 3117 and the first shaft 311 is fastened. Similarly, the second stop member 3118 is sleeved on the second shaft 312, and in the rotation direction of the second shaft 312, a relative location between the second stop member 3118 and the second shaft 312 is fastened.

In addition, the first stop member 3117 includes a seventh stop portion 31171, the seventh stop portion 31171 is disposed toward the conjoined cam 316, and the second stop portion 3161 of the conjoined cam 316 is located on a motion trajectory along which the seventh stop portion 31171 rotates around the axis of the first shaft 311. In addition, the second stop member 3118 includes an eighth stop portion 31181, the eighth stop portion 31181 is disposed toward the conjoined cam 316, and the fourth stop portion 3162 of the conjoined cam 316 is located on a motion trajectory along which the eighth stop portion 31181 rotates around the axis of the second shaft 312.

It may be understood that, in the rotation process of the first shaft 311, when the seventh stop portion 31171 of the first stop member 3117 abuts against the second stop portion 3161 of the conjoined cam 316, the first shaft 311 stops rotating. In addition, in the rotation process of the second shaft 312, when the eighth stop portion 31181 of the second stop member 3118 abuts against the fourth stop portion 3162 of the conjoined cam 316, the second shaft 312 stops rotating. In other words, when the first stop member 3117 abuts against the conjoined cam 316 and the second stop member 3118 abuts against the conjoined cam 316, the first support plate 201 stops rotating toward a side away from the body 1, so that the support component 2 stops rotating relative to the body 1.

It can be learned that, in this application, disposition locations of the second stop portion 3161 and the fourth stop portion 3162 of the conjoined cam 316, the seventh stop portion 31171 of the first stop member 3117, and the eighth stop portion 31181 of the second stop member 3118 may be adjusted to adjust rotation angles of the first shaft 311 and the second shaft 312. In this way, a maximum angle of relative rotation between the first support plate 201 and the body 1 is adjusted. For example, in this application, disposition locations of the second stop portion 3161 and the fourth stop portion 3162 of the conjoined cam 316, the seventh stop portion 31171 of the first stop member 3117, and the eighth stop portion 31181 of the second stop member 3118 may be adjusted, so that a maximum angle at which the first support plate 201 rotates relative to the body 1 is approximately 180°. In this way, the outer surface of the first support plate 201 and the outer surface of the body 1 can be coplanar, which helps improve support stability of the triangular support structure formed by the support component 2.

Still as shown in FIG. 18, the rotating shaft assembly 31 further includes a connecting member 3119, the connecting member 3119 is sleeved on the first shaft 311 and the second shaft 312, the connecting member 3119 may be located on a side that is of the first helical surface 31101 and that is away from the first fastening bracket 313, and the connecting member 3119 is located on a side that is of the second helical surface 3122 and that is away from the second fastening bracket 314. In this way, a rotating shaft 31161 of the idler gear 3116 may be installed on the connecting member 3119, which helps improve structural reliability of the rotating shaft assembly 31, and may make a structure of the rotating shaft assembly 31 compact, thereby facilitating implementation of a miniaturization design of the rotating shaft assembly 31. In some possible embodiments, the connecting member 3119 may also be disposed at another location of the rotating shaft assembly 31, and the rotating shaft 31161 of the idler gear 3116 may also be installed on another structure of the rotating shaft assembly 31. This is not specifically limited herein.

In the rotating shaft assembly 31 shown in FIG. 18, the first stop member 3117 is located between the connecting member 3119 and the conjoined cam 316, and the second stop member 3118 is located between the connecting member 3119 and the conjoined cam 316. The first stop member 3117 may further include a ninth stop portion 31172, the ninth stop portion 31172 is disposed toward the connecting member 3119, the second stop member 3118 may further include a tenth stop portion 31182, and the tenth stop portion 31182 is disposed toward the connecting member 3119. In addition, the connecting member 3119 includes an eleventh stop portion 31191 and a twelfth stop portion 31192. When the ninth stop portion 31172 abuts against the eleventh stop portion 31191 and the tenth stop portion 31182 abuts against the twelfth stop portion 31192, that is, when the first stop member 3117 abuts against the connecting member 3119 and the second stop member 3118 abuts against the connecting member 3119, the first support plate 201 stops rotating toward a side away from the body 1, so that the support component 2 stops rotating relative to the body 1.

It may be understood that, in this application, disposition locations of the connecting member 3119, the conjoined cam 316, and stop portions of the first stop member 3117 and the second stop member 3118 may be adjusted, so that the connecting member 3119 and the conjoined cam 316 have a same limitation on stop locations of the first stop member 3117 and the second stop member 3118. This helps improve reliability of limiting a rotation location of the support component 2 relative to the body 1.

In addition, the rotating shaft assembly 31 shown in FIG. 18 also includes the first cam member 318 and the second cam member 319. The first cam member 318 and the second cam member 319 may be disposed based on the first cam member 318 and the second cam member 319 described in the foregoing embodiments. Details are not described herein again.

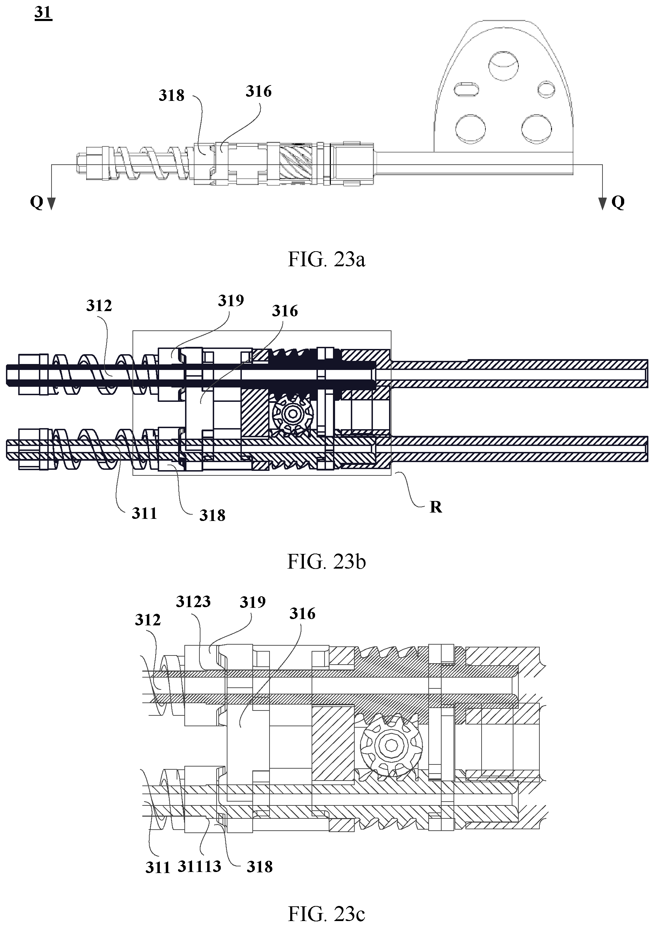

In the rotating shaft assembly shown in FIG. 18, because the first shaft 311 and the second shaft 312 may rotate synchronously, a limiting structure may be designed for each of the first shaft 311 and the second shaft 312, to control torque undergone by the first shaft 311 and the second shaft 312 in the rotation process. During specific implementation, FIG. 23a is a diagram of a structure of the rotating shaft assembly 31 shown in FIG. 17 from another perspective. FIG. 23b is a sectional view along Q-Q of the rotating shaft assembly shown in FIG. 23a. In addition, FIG. 23c is an enlarged view of a partial structure at a location R of a structure shown in FIG. 23b. The first shaft 311 includes a first limiting structure 31113, and the second shaft 312 includes a second limiting structure 3123. In the closed state, the first cam member 318 abuts against the end face of the first limiting structure 31113 along the axial direction of the first shaft 311, and the second cam member 319 abuts against the end face of the second limiting structure 3123 along the axial direction of the second shaft 312. For an implementation in which the second cam member 319 abuts against the second limiting structure 3123, refer to the foregoing descriptions of the implementation in which the first cam member 318 abuts against the first limiting structure 31113. Details are not described herein again.

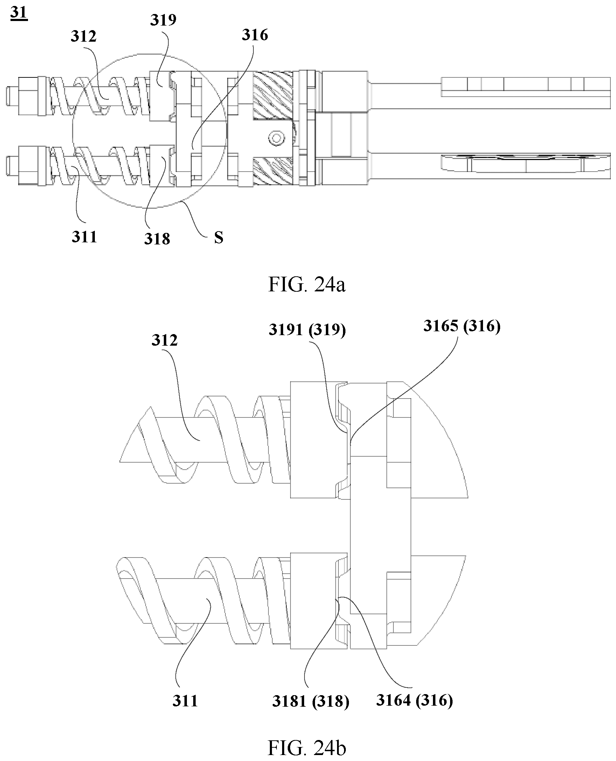

FIG. 24a is a diagram of a structure of the rotating shaft assembly 31 shown in FIG. 17 from another perspective. In addition, FIG. 24b is an enlarged view of a partial structure at a location S of the rotating shaft assembly shown in FIG. 24a. Under an abutting effect between the first cam surface 3181 of the first cam member 318 and the first limiting structure 31113, there may be a clearance fit between the first cam surface 3181 of the first cam member 318 and the third cam surface 3164 of the conjoined cam 316. Similarly, under an abutting effect between the second cam surface 3191 of the second cam member 319 and the second limiting structure 3123, there may be a clearance fit between the second cam surface 3191 of the second cam member 319 and the fourth cam surface 3165 of the conjoined cam 316. In this way, in a process of changing from the closed state to the open state, the first shaft 311 and the second shaft 312 undergo small torque during rotation. This can facilitate opening of the entire electronic device.

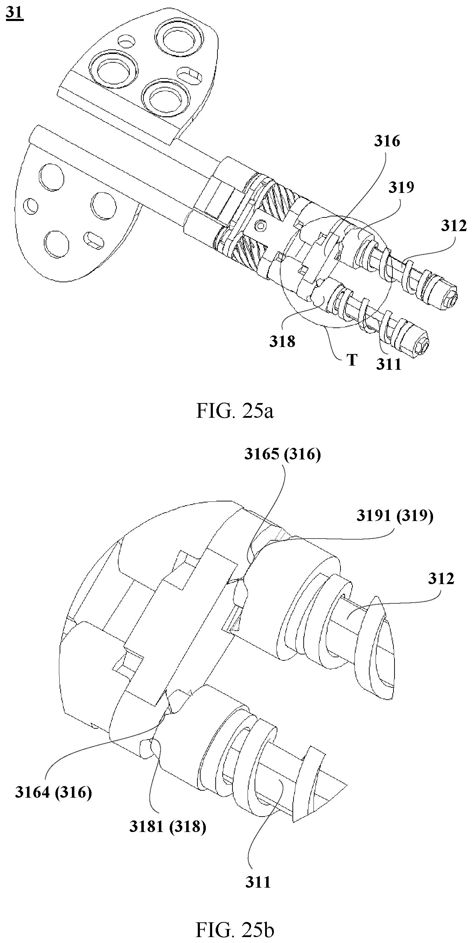

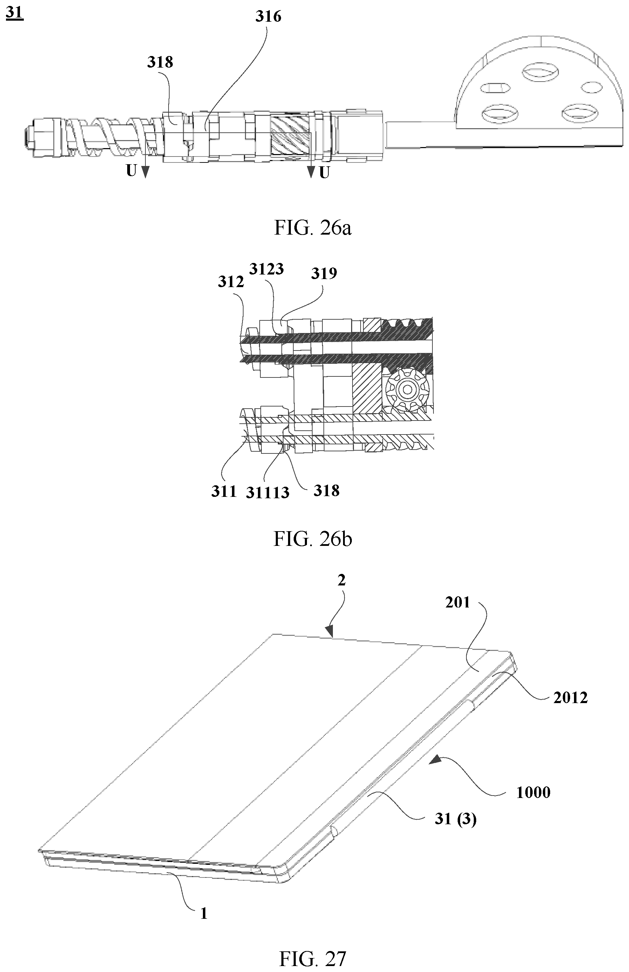

However, with rotation of the first shaft 311 and the second shaft 312, FIG. 25a is a diagram of a structure of the rotating shaft assembly 31 shown in FIG. 21a from another perspective. FIG. 25b is an enlarged view of a partial structure at a location T of the rotating shaft assembly 31 shown in FIG. 25a. The first cam surface 3181 and the third cam surface 3164 abut against each other, and the second cam surface 3191 and the fourth cam surface 3165 abut against each other. In this case, FIG. 26a is a diagram of a structure of the rotating shaft assembly 31 shown in FIG. 21a from another perspective. FIG. 26b is a sectional view along U-U of the rotating shaft assembly 31 shown in FIG. 26a. The first limiting structure 31113 does not limit the first cam member 318, and the second limiting structure 3123. In this way, the elastic acting force of the first elastic component 3110 is transferred to the conjoined cam 316 through the first cam member 318, so that the torque undergone by the first shaft 311 during rotation increases. In addition, the elastic acting force of the second elastic component 3112 is transferred to the conjoined cam 316 through the second cam member 319, so that the torque undergone by the second shaft 312 through rotation increases. In this way, when the electronic device is opened to be in the use state, this effectively reduces a risk that the entire system shakes due to loosening of the first shaft 311 and the second shaft 312, thereby improving stability of using the electronic device and improving user experience.

It should be noted that, in the rotating shaft assembly 31 provided in this application, torque of the first shaft 311 and the second shaft 312 in the rotation process is controlled by adding the limiting structure, so that the torque undergone by the first shaft 311 and the second shaft 312 at a specific rotation angle can be effectively removed. In addition, an implementation means is easy to control, and manufacturing costs are low.

In some other possible embodiments of this application, the first shaft 311 and the second shaft 312 may further have variable torque in the rotation process by increasing rigidity of the elastic element, increasing a height difference between protrusions of cam surfaces that abut against each other, or the like. Details are not described herein, but it should be understood that this falls within the protection scope of this application.

In addition, based on the foregoing design principle of the variable torque, when the first shaft 311 and the second shaft 312 of the rotating shaft assembly 31 synchronously rotate in another manner, the limiting structure may be further disposed at a proper location based on a specific design requirement, to implement a variable torque design of the rotating shaft assembly 31 in the movement process. Examples are not listed one by one herein, but it should be understood that this falls within the protection scope of this application.

Other structures of the rotating shaft assembly 31 shown in FIG. 17 to FIG. 26b may be disposed with reference to any one of the foregoing embodiments. Details are not described herein again.

The foregoing embodiments are merely some examples for describing a disposition manner of the rotating shaft assembly 31 of a dual-shaft structure provided in this application. Based on this, adaptive variations may be further made based on a specific application scenario. Examples are not listed one by one herein, but it should be understood that this falls within the protection scope of this application.

It may be understood that, in this embodiment of this application, to implement a rotatable connection between the support component 2 and the body 1, in addition to the dual-shaft structure, the rotating shaft assembly 31 may further be of another possible structure. The following describes some other possible disposition manners of the rotating shaft assembly.

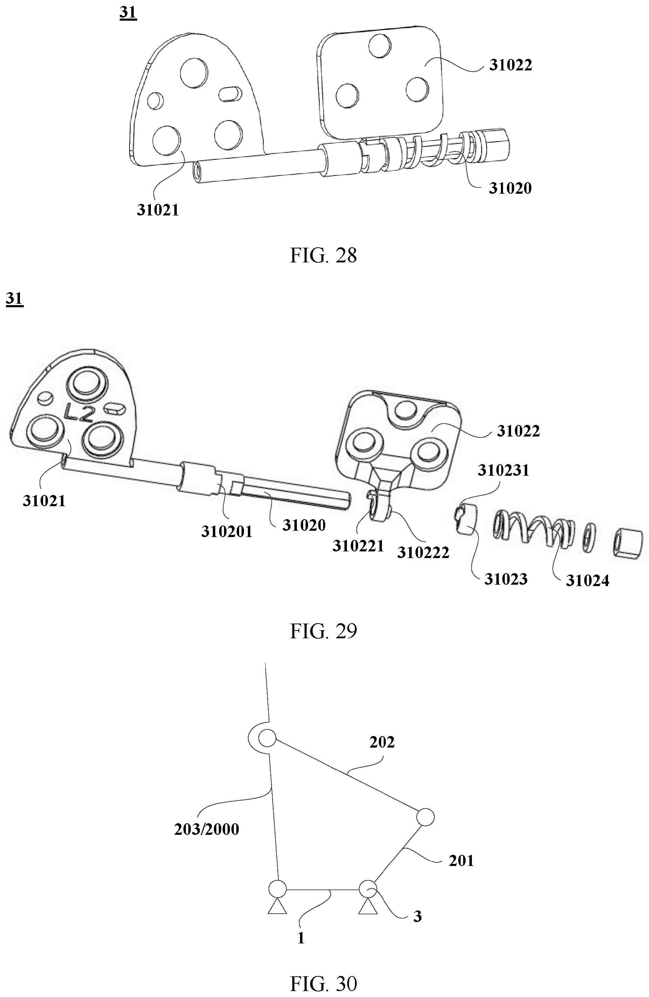

FIG. 27 is a diagram of another structure of an accessory apparatus according to an embodiment of this application. In an accessory apparatus 1000, a rotating shaft assembly 31 of a rotating module 3 is of a single-shaft structure. In other words, the rotating shaft assembly includes only one rotating shaft. Specifically, FIG. 28 is a diagram of a structure of a rotating shaft assembly of the accessory apparatus shown in FIG. 27. The rotating shaft assembly 31 includes a third shaft 31020, a second plate edge 2012 of a first support plate 201 is rotatably connected to the third shaft 31020, and an end portion of a body 1 is rotatably connected to the third shaft 31020. In this case, the first support plate 201 and the body 1 each are rotatably connected to the third shaft 31020, which helps simplify a structure of the rotating module 3, and helps implement a lightweight and thin design of the accessory apparatus 1000.

FIG. 29 is an exploded view of the rotating shaft assembly shown in FIG. 28. In this embodiment, the rotating shaft assembly 31 further includes a third fastening bracket 31021 and a fourth fastening bracket 31022. The third fastening bracket 31021 is configured to drive the third shaft 31020 to rotate synchronously. The third fastening bracket 31021 may be disposed at any location of the third shaft 31020. For example, the third fastening bracket 31021 is disposed at an end portion of the third shaft 31020. In addition, the third fastening bracket 31021 is detachably connected to the third shaft 31020, or the third fastening bracket 31021 and the third shaft 31020 are of an integral structure. This is not limited in this application.

As shown in FIG. 28 and FIG. 29 together, the fourth fastening bracket 31022 is sleeved on the third shaft 31020, and the fourth fastening bracket 31022 is rotatably connected to the third shaft 31020. In this way, the third fastening bracket 31021 may be fastened to the second plate edge 2012 of the first support plate 201, and the fourth fastening bracket 31022 may be fastened to an end portion of the body 1, so that the first support plate 201 may rotate relative to the body 1 through the rotating shaft assembly 31, thereby implementing a rotatable connection between a support component 2 and the body 1.

Still as shown in FIG. 29, the third shaft 31020 is further provided with a thirteenth stop portion 310201. The fourth fastening bracket 31022 includes a fourteenth stop portion 310221. In addition, the thirteenth stop portion is located on a motion trajectory along which the fourteenth stop portion rotates around an axis of the third shaft 31020. Therefore, in a process in which the fourth fastening bracket 31022 rotates relative to the third shaft 31020, when the thirteenth stop portion 310201 abuts against the fourteenth stop portion 310221, the fourth fastening bracket 31022 stops rotating.

It can be learned that, in this application, disposition locations of the thirteenth stop portion 310201 and the fourteenth stop portion 310221 may be adjusted, to adjust an angle at which the fourth fastening bracket 31022 rotates relative to the third shaft 31020. In this way, a maximum angle of relative rotation between the first support plate 201 and the body 1 is adjusted. For example, in this application, when the thirteenth stop portion 310201 abuts against the fourteenth stop portion 310221, a maximum angle at which the first support plate 201 rotates relative to the body 1 is approximately 180°, so that an outer surface of the first support plate 201 and an outer surface of the body 1 can be coplanar, which helps improve support stability of a triangular support structure formed by the support component 2.

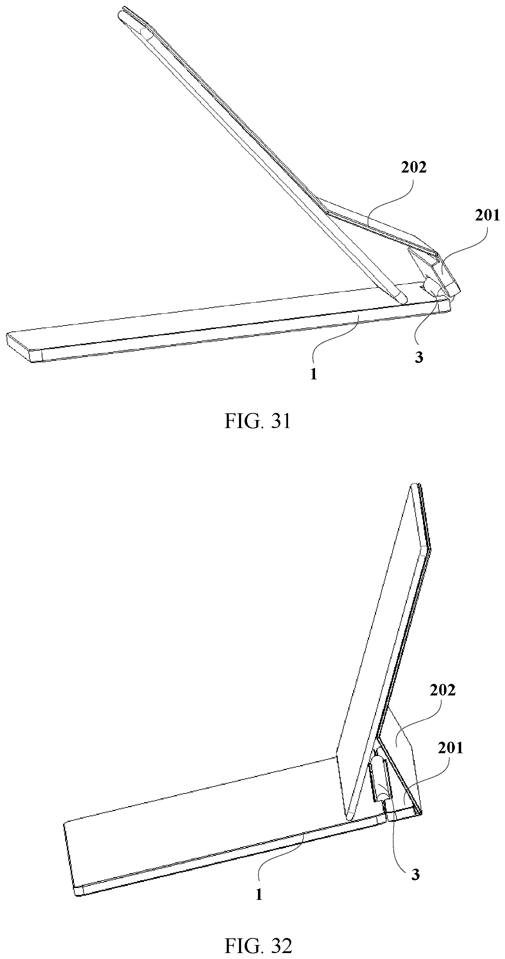

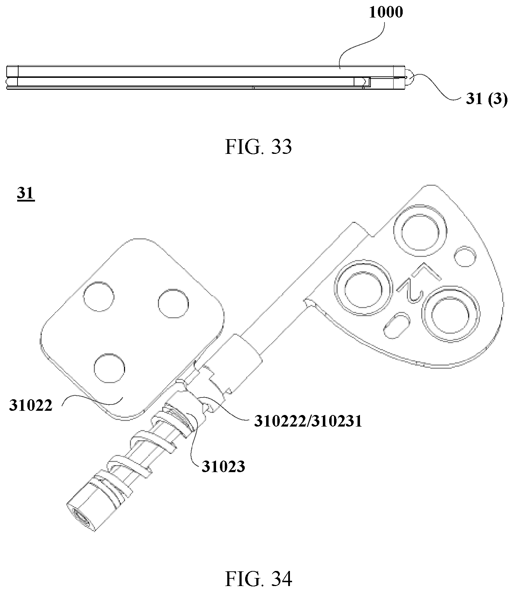

In addition, FIG. 30 is a principle diagram of a motion mechanism of the accessory apparatus shown in FIG. 27. It can be learned from FIG. 30 that, movement of the support component 2 of the accessory apparatus 1000 around the body 1 may be equivalent to four-link transmission. The first support plate 201, a second support plate 202, a third support plate 203, a host 2000, and the body 1 each may be considered as a member, and a kinematic pair between the first support plate 201 and the body 1, a kinematic pair between the second support plate 202 and the first support plate 201, and a kinematic pair between the second support plate 202 and an entirety of the third support plate 203 and the host 2000 each are a lower pair. Therefore, the four-link transmission mechanism includes only four lower pairs. Therefore, degree of freedom of four-link transmission mechanism=3×3-2×4=1. Therefore, it can be understood that the degree of freedom of the four-link transmission mechanism is unique. In other words, a motion trajectory of each member of the four-link transmission mechanism is unique. FIG. 31 is a diagram of a structure in which an electronic device is opened to a specified angle. Therefore, in a process in which the support component 2 of the accessory apparatus 1000 rotates around the body 1, a rotation trajectory of each support plate is unique, which helps implement opening of the accessory apparatus 1000 in one step. In addition, when the accessory apparatus 1000 is in an open state shown in FIG. 32, coplanarity between the outer surface of the first support plate 201 and the outer surface of the body 1 can be improved, to improve appearance flatness of the accessory apparatus 1000. In addition, as shown in FIG. 33, when the accessory apparatus 1000 is in a closed state, the rotating module 3 of the accessory apparatus 1000 is designed in a convex manner, which helps implement different appearance designs of the accessory apparatus 1000.

Still as shown in FIG. 29, the rotating shaft assembly 31 further includes a third cam member 31023, and the third cam member 31023 is sleeved on the third shaft 31020. An end portion that is of the third cam member 31023 and that faces the fourth fastening bracket 31022 includes a fifth cam surface 310231, and an end portion that is of the fourth fastening bracket 31022 and that faces the third cam member 31023 includes a sixth cam surface 310222.

In addition, the rotating shaft assembly 31 further includes a third elastic component 31024, the third cam member 31023 is located between the fourth fastening bracket 31022 and the third elastic component 31024, and the third elastic component 31024 abuts against an end face that is of the third cam member 31023 and that is away from the fourth fastening bracket 31022. Therefore, under an elastic acting force of the third elastic component, the fifth cam surface 310231 of the third cam member 31023 may abut against the sixth cam surface 310222 of the fourth fastening bracket 31022.

It may be understood that a design solution of variable-torque rotation of the rotating shaft mentioned above in this application may also be applied to the rotating shaft assembly 31 of the single-shaft structure. During specific implementation, as shown in FIG. 29, the third shaft 31020 may include a third limiting structure 310202. In the closed state, the fifth cam surface 310231 of the third cam member 31023 abuts against an end face of the third limiting structure 310202 along an axial direction of the third shaft 31020, so that there is a clearance fit between the fifth cam surface 310231 and the sixth cam surface 310222. In this way, in a process of changing from the closed state to the open state, the fourth fastening bracket 31022 and the third shaft 31020 undergo small torque during rotation. This can facilitate opening of the entire electronic device.

However, with relative rotation between the fourth fastening bracket 31022 and the third shaft 31020, FIG. 34 is a diagram of a structure of a rotating shaft assembly 31 when an accessory apparatus is in the open state shown in FIG. 32. In this case, the fifth cam surface 310231 abuts against the sixth cam surface 310222, and the elastic acting force of the third elastic component 31024 is transferred to the fourth fastening bracket 31022 through the third cam member 31023, so that torque undergone by the fourth fastening bracket 31022 and the third shaft 31020 increases. In this way, when the electronic device is opened to be in a use state, a risk that the entire device shakes due to loosening of the fourth fastening bracket 31022 and the third shaft 31020 can be effectively reduced, thereby improving stability of using the electronic device and improving user experience.

In the rotating shaft assembly shown in FIG. 29, torque of the third shaft 31020 and the fourth fastening bracket 31022 in a rotation process is controlled by adding a limiting structure, so that torque undergone by the third shaft 31020 and the fourth fastening bracket 31022 at a specific rotation angle can be effectively removed. In addition, an implementation means is easy to control, and manufacturing costs are low.

In some other possible embodiments of this application, the third shaft 31020 and the fourth fastening bracket 31022 may further have variable torque in the rotation process by increasing rigidity of an elastic element, increasing a height difference between protrusions of cam surfaces that abut against each other, or the like. Details are not described herein, but it should be understood that this falls within the protection scope of this application.

Other structures of the rotating shaft assembly 31 shown in FIG. 29 may be disposed with reference to any one of the foregoing embodiments. Details are not described herein again.

The foregoing embodiments are merely some examples for describing a disposition manner of the rotating module 3 provided in this application. Based on this, adaptive variations may be further made based on a specific application scenario. Examples are not listed one by one herein, but it should be understood that this falls within the protection scope of this application.

It can be learned from the foregoing descriptions of the accessory apparatus 1000 provided in this application that the first support plate 201 and the second support plate 202 of the support component 2 are also rotatably connected. In this application, a specific connection manner between the first support plate 201 and the second support plate 202 is not limited. For example, a flexible material may be used for a flexible connection. A material of a flexible material layer may be but is not limited to leather. The flexible material layer is connected to a first plate edge 2011 of the first support plate 201, and the flexible material layer is connected to a third plate edge 2021 of the second support plate 202.

In addition, the second support plate 202 and the third support plate 203 of the support component 2 may alternatively be rotatably connected through the flexible material layer, and the first support plate 201, the second support plate 202, and the third support plate 203 may be connected through a same flexible material layer. This can improve connection reliability of each structure, and further help simplify a structure of the accessory apparatus 1000.

In some possible embodiments, rotatably connected support plates in the support component 2 may alternatively be rigidly connected through a rigid connecting member, to effectively reduce a case in which the connected support plates are deadly bent or overbent in a relative rotation process. This can effectively improve movement smoothness of the support component 2, thereby improving user experience.

It can be learned from the foregoing descriptions of the support component 2 of the accessory apparatus 1000 that the third support plate 203 is configured to be connected to the host 2000, so that the third support plate 203 and the host 2000 move as an entirety. When the electronic device is in the open state, the host 2000, the third support plate 203, the second support plate 202, the first support plate 201, and the body 1 form an approximately triangular support structure, so that the electronic device is stably maintained in the open state.

In some possible embodiments, some adaptive deformations may be further performed on the structure of the accessory apparatus 1000, so that the accessory apparatus 1000 may also form an approximately triangular support structure. For example, in the open state, a fifth plate edge 2031 of the third support plate 203 extends to the body 1, and the fifth plate edge 2031 may abut against the body 1. Therefore, even if there is no connection structure between the host 2000 and the body 1, the third support plate 203, the second support plate 202, the first support plate 201, and the body 1 may form an approximately triangular support structure, so that the accessory apparatus 1000 stably supports the host 2000. This helps expand an application scenario range of the accessory apparatus 1000.

In the accessory apparatus 1000 provided in this embodiment of this application, a multi-link transmission principle is used, to form reliable support for the host of the electronic device while meeting a requirement for opening the electronic device in one step. A structure of the accessory apparatus is simple. This helps implement a miniaturization design of the accessory apparatus 1000, and further meets a design requirement for light weight, thinness, and miniaturization of the electronic device, to meet a portability requirement of a user and improve user experience.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. An accessory apparatus, wherein the accessory apparatus comprises a body, a first support plate, a second support plate, a third support plate, and a rotating shaft assembly, the first support plate, the second support plate, and the third support plate are rotatably connected in sequence, and the first support plate is rotatably connected to an end portion of the body by using the rotating shaft assembly;
the rotating shaft assembly comprises a first shaft, a second shaft, a conjoined cam, a first cam member, and a second cam member, an axis of the first shaft and an axis of the second shaft are parallel and do not overlap, the first shaft is fastened to the first support plate, and the second shaft is fastened to an end portion of the body; and
the conjoined cam is sleeved on the first shaft and the second shaft, the first cam member is sleeved on the first shaft, and the second cam member is sleeved on the second shaft; the first shaft comprises a first limiting structure, and when the accessory apparatus is in a closed state, the first cam member abuts against an end face of the first limiting structure along an axial direction of the first shaft, and there is a clearance fit between the first cam member and the conjoined cam; and when the first shaft rotates to a specified angle, the first cam member abuts against the conjoined cam.

2. The accessory apparatus according to claim 1, wherein the first shaft comprises a first rotating wheel, the first rotating wheel and the first shaft are coaxially disposed, and a peripheral side surface of the first rotating wheel comprises a first groove; the second shaft comprises a second rotating wheel, the second rotating wheel and the second shaft are coaxially disposed, and a peripheral side surface of the second rotating wheel comprises a second groove; and the first groove and the second groove are staggered; and
the rotating shaft assembly further comprises a transfer wheel, and the transfer wheel is located between the first rotating wheel and the second rotating wheel; when the accessory apparatus is in the closed state, a part of the transfer wheel is accommodated in the second groove; and when the first shaft stops rotating around the axis and the second shaft rotates around the axis, a part of the transfer wheel is accommodated in the first groove.

3. The accessory apparatus according to claim 2, wherein the first rotating wheel comprises a first stop portion, and the conjoined cam comprises a second stop portion; and when the first stop portion abuts against the second stop portion, the first shaft stops rotating around the axis.

4. The accessory apparatus according to claim 3, wherein the rotating shaft assembly further comprises a snap-fit, the snap-fit is snap-fitted to the first shaft, and the snap-fit is snap-fitted to the second shaft; the conjoined cam comprises a first elongated hole, the snap-fit comprises a second elongated hole, and the first elongated hole is disposed opposite to the second elongated hole; and the transfer wheel is located between the snap-fit and the conjoined cam, the transfer wheel comprises a first guiding portion and a second guiding portion that are disposed back to back, the first guiding portion is inserted into the first elongated hole, and the second guiding portion is inserted into the second elongated hole.

5. The accessory apparatus according to any one of claims 2 to 4, wherein the first rotating wheel and the first shaft are of an integral structure, and the second rotating wheel and the second shaft are of an integral structure.

6. The accessory apparatus according to claim 1, wherein the first shaft comprises a first helical surface, the second shaft comprises a second helical surface, and the first helical surface and the second helical surface have a same rotation direction; and
the rotating shaft assembly further comprises an idler gear, the idler gear is located between the first helical surface and the second helical surface, the first helical surface is engaged with a tooth flank of the idler gear, and the second helical surface is engaged with a tooth flank of the idler gear.

7. The accessory apparatus according to claim 6, wherein the second shaft comprises a second limiting structure; when the accessory apparatus is in the closed state, the second cam member abuts against an end face of the second limiting structure along an axial direction of the second shaft, and there is a clearance fit between the second cam member and the conjoined cam; and when the second shaft rotates to a specified angle, the second cam member abuts against the conjoined cam.

8. The accessory apparatus according to claim 6 or 7, wherein the rotating shaft assembly further comprises a connecting member, a first stop member, and a second stop member, the connecting member is sleeved on the first shaft and the second shaft, the first stop member is sleeved on the first shaft, and the second stop member is sleeved on the second shaft; in a rotation direction of the first shaft, a relative location between the first stop member and the first shaft is fixed; in a rotation direction of the second shaft, a relative location between the second stop member and the second shaft is fixed; and
when the first stop member abuts against the connecting member and the second stop member abuts against the connecting member, the first support plate stops rotating toward a side away from the body.

9. The accessory apparatus according to claim 8, wherein the first stop member is located between the connecting member and the conjoined cam, and the second stop member is located between the connecting member and the conjoined cam.

10. The accessory apparatus according to any one of claims 1 to 9, wherein the rotating shaft assembly further comprises a first elastic component and a second elastic component, the first elastic component is sleeved on the first shaft, the first cam member is located between the conjoined cam and the first elastic component, and the first elastic component abuts against an end face that is of the first cam member and that is away from the conjoined cam; and
the second elastic component is sleeved on the second shaft, the second cam member is located between the conjoined cam and the second elastic component, and the second elastic component abuts against an end face that is of the second cam member and that is away from the conjoined cam.

11. An accessory apparatus, wherein the accessory apparatus comprises a body, a first support plate, a second support plate, a third support plate, and a rotating shaft assembly, the first support plate, the second support plate, and the third support plate are rotatably connected in sequence, and the first support plate is rotatably connected to an end portion of the body by using the rotating shaft assembly; and
the rotating shaft assembly comprises a third shaft, a third fastening bracket, and a fourth fastening bracket, and the third fastening bracket is configured to drive the third shaft to rotate synchronously; the fourth fastening bracket is rotatably connected to the third shaft; and the third fastening bracket is fastened to the second plate edge of the first support plate, and the fourth fastening bracket is fastened to an end portion of the body.

12. The accessory apparatus according to claim 11, wherein the third shaft comprises a thirteenth stop portion, and the fourth fastening bracket comprises a fourteenth stop portion; and when the thirteenth stop portion abuts against the fourteenth stop portion, the fourth fastening bracket stops rotating.

13. The accessory apparatus according to claim 11 or 12, wherein the rotating shaft assembly further comprises a third cam member, and the third shaft comprises a third limiting structure; when the accessory apparatus is in a closed state, the third cam member abuts against an end face of the third limiting structure along an axial direction of the third shaft, and there is a clearance fit between the third cam member and the fourth fastening bracket; and when the third shaft rotates to a specified angle, the third cam member abuts against the fourth fastening bracket.

14. The accessory apparatus according to claim 13, wherein the rotating shaft assembly further comprises a third elastic component, the third cam member is located between the fourth fastening bracket and the third elastic component, and the third elastic component abuts against an end face that is of the third cam member and that is away from the fourth fastening bracket.

15. An electronic device, comprising a host and the accessory apparatus according to any one of claims 1 to 14, wherein the third support plate of the accessory apparatus is detachably connected to the host.
